# EUROPÄISCHE PATENTSCHRIFT

(11) **EP 2 600 554 B1**
(45) Veröffentlichungstag und Bekanntmachung des Hinweises auf die Patenterteilung: **13.09.2017**
(21) Anmeldenummer: 12194920.0
(22) Anmeldetag: 29.11.2012
(51) Int. Cl.: H04L 1/00, H04L 27/26, H04N 5/50, H04N 5/455, H04B 1/10

(54) **TV-Empfangsteil mit Eingangsfiltermitteln zum Unterdrücken von Störleistung in einem Eingangskreis**
TV reception component with input filter for suppressing interference in an input circuit
Pièce de réception TV avec élément de filtre d'entrée pour la contention de puissances d'interférence dans un circuit d'entrée

(30) Priorität: 02.12.2011 DE 102011087682
(43) Veröffentlichungstag der Anmeldung: 05.06.2013
(73) Patentinhaber: TechniSat Digital GmbH, 54550 Daun (DE)
(72) Erfinder: Giessmann, Sebastian, Dipl.-Ing. (FH), 01159 Dresden (DE)

(56) Entgegenhaltungen:
- WO-A1-03/092160
- US-A1- 2011 212 698

## Beschreibung

Der Gegenstand der vorliegenden Patentanmeldung betrifft ein TV-Empfangsteil mit Filtermitteln zum Unterdrücken von Störleistung in einem Eingangskreis einer HF-Abstimmeinheit verursacht durch Sendespektren von terrestrisch empfangenen Funkdiensten.

Insbesondere dient die Erfindung zum Unterdrücken von Störleistung im Empfangssignal von terrestrischen oder über ein Kabelnetz empfangenen Fernsehdiensten, die einen TV-Kanal innerhalb eines Rundfunkbandes nutzen, welches ein Frequenzunterband von 790 MHz bis 862 MHz einschließt bzw. nach dem Jahr 2016 zusätzlich ein zweites Frequenzunterband von 694 bis 790 MHz einschließen wird.

Die Erfindung löst speziell ein Problem, welches dadurch entsteht, dass die internationale Frequenzkoordination in den genannten Frequenzunterbändern neben einer primären Nutzung für terrestrische Fernsehrundfunkdienste einschließlich drahtloser Mikrofon- und In-Ohr-Monitorsysteme oder Kabelfernsehen (DVB-C) schrittweise einen zusätzlichen Betrieb von weiteren Funkdienstarten zulässt.

Die Koexistenz von terrestrischem Fernsehrundfunk und benachbarten Sendespektren von Mobilfunk belasten beispielsweise den Eingangskreis des TV-Empfangsteils eines Fernsehempfängers.

### Technischer Hintergrund der Erfindung

Für die vorliegende Anmeldung ist es unerheblich, ob das TV-Empfangsteil in einem Fernsehempfänger mit oder ohne integrierten Bildwiedergabeschirm angeordnet ist. Ein Vorschalt-Empfänger, eine sogenannte 'Set-Top-Box', ist somit auch ein Fernsehempfänger im Sinne der vorliegenden Patentanmeldung.

Für terrestrischen Fernsehrundfunk stehen mehrere Funkbändern zur Verfügung. Neben dem als Fernsehband III bezeichneten VHF-High-Band mit Trägerfrequenzen von etwa 174 MHz bis 230 MHz werden oberhalb von 470 MHz auch UHF-Bänder IV und V für Fernsehrundfunk genutzt. Beide UHF-Bänder erlauben in Europa gegenwärtig noch terrestrischen Fernsehrundfunk und Kabelfernsehen auf Trägerfrequenzen von 471 MHz bis 862 MHz in Fernsehkanälen 21 bis 69 bei einem Kanalabstand von 8 MHz. Der Frequenzbereich des UHF-Bandes V war bisher bis zu einer Grenzfrequenz f_{Bu} = 862 MHz primär dem terrestrischen Fernsehrundfunk zugewiesen worden und wird auch bis zu dieser Grenzfrequenz in Kabelfernsehnetzen genutzt.

Nachfolgend werden terrestrischer Fernsehrundfunk und Kabelfernsehen als ,TV-Dienste' bezeichnet.

Ein Umstellen der TV-Dienste von analoger Signalmodulation auf digitalen Videorundfunk, in Europa beispielsweise auf DVB-T beziehungsweise DVB-C, führte zu einer höheren Kanaleffizienz und benötigt wesentlich weniger Übertragungsbandbreite. Als Konsequenz der gestiegenen Kanaleffizienz steht heute den digitalen TV-Diensten in den Funkbändern eine mehrfache Übertragungskapazität zur Verfügung als zur Zeit der ursprünglichen Bandzuweisung. Jedes Sendespektrum eines DVB-T-Senders überträgt in einem etwa 8 MHz breiten Fernsehkanal in der Regel an die Stelle eines analogen TV-Dienstes gemeinsam mehre digitale TV-Dienste.

Die Übertragung erfolgt im Prinzip nach einem Mehrträgerverfahren, beispielsweise bei DVB-T-Sendern nach dem sogenannten Coded Orthogonal Frequency Division Multiplex COFDM. Dieses Verfahren verteilt und verschachtelt die Information auf viele, nebeneinander liegende Unterträgerfrequenzen innerhalb des DVB-T-Sendespektrums, wobei vorher entsprechende Fehlerschutzinformation hinzugefügt wird.

Infolge der höheren Kanaleffizienz entschied die Internationale Fernmeldeunion ITU die bislang primäre Frequenzzuweisung von terrestrischem Fernsehrundfunk zum Rundfunkband V am oberen Frequenzbereich des Rundfunkbandes V einzuschränken. Im Rahmen einer sogenannten Digitalen Dividende wird zunächst ein Frequenzunterband im Frequenzbereich von 790 MHz bis 862 MHz, das die TV-Kanäle 61 bis 69 enthält und in der Fachwelt auch als '800-MHz-Band' bezeichnet wird, für eine zusätzliche Nutzung durch weitere Funkdienstarten freigegeben. In der Zukunft darf das 800-MHz-Band zusätzlich für mobile drahtlose Breitband-Internetzugänge und andere Mobilfunkanwendungen wie beispielsweise WLAN genutzt werden.

Zum Prioritätstag der Anmeldung waren in Deutschland bereits die früheren Fernsehkanäle 61 bis 69 für mobile Internetdienste vergeben und für Mobilfunk nach dem Breitband-Mobilfunk-Standard ,3GPP Long Term Evolution', wie dem Mobilfunksystem LTE, genutzt. Wie auch andere Mobilfunknetze besitzt das LTE-Netz wabenartig strukturierte Funkzellen mit jeweils einer zentralen Basisstation. Daher können an einem Empfangsort die Sendespektren mehrerer Basisstationen im 800-MHz-Band vorliegen.

Darüber hinaus ist für das Jahr 2015 eine Entscheidung der World Radio Conference (WRC) beabsichtigt, welche in Form einer zweiten digitalen Dividende zusätzlich auch ein weiteres Frequenzunterband im Frequenzbereich von 694 MHz bis 790 MHz, das sogenannte, 700-MHz Band' neben der primären Nutzung für Fernsehrundfunk, drahtlose Mikrofon- und In-Ohr-Monitorsysteme zur Nutzung durch weitere Funkdienstarten freigeben kann. In Westeuropa werden dann die DVB-T Kanäle 49 bis 60 betroffen sein. In den USA steht der Frequenzbereich oberhalb von 698 MHz bereits seit Mitte 2009 nicht mehr für terrestrischen Fernsehrundfunk zur Verfügung.

In einem LTE-Netz liegen bekanntlich die Sendespektren der mobilen Endgeräte über den Sendespektren der Basisstationen. Die Basisstationen senden zu den mobilen Endgeräten in einem Frequenzbereich von 791 MHz bis 821 MHz. Die mobilen Endgeräte senden zu den Basisstationen in einem Frequenzbereich von 832 MHz bis 862 MHz. Zwischen beiden Frequenzbereichen liegt eine Duplexlücke von 11 MHz, welche die Bandbreite des TV-Kanals 65 überschreitet. Im Gegensatz dazu ist der TV-Kanal 60 bei f_{Tu} = 790 MHz nur durch einen Sicherheitsabstand von 1 MHz vom untersten Sendespektrum der Basisstationen getrennt.

Somit können die Sendespektren von DVB-Sendern und von LTE-Basisstationen besonders nahe zueinander liegen. Unter bestimmten Voraussetzungen sind die Frequenzabstände zwischen den Sendespektren der LTE-Basisstationen und einem DVB-Sender sogar geringer als die Duplexlücke zwischen den beiden Frequenzbereichen innerhalb der LTE-Netze. Dieses ist dann gegeben, wenn der DVB-Sender den TV-Kanal 60 bei 790 MHz nutzt und LTE-Basisstationen im Frequenzbereich von 791 bis 801 MHz arbeiten.

Für das 800-MHz-Band und gegeben Falls auch für das 700-MHz-Band kann ein Fernsehempfängernutzer in den nächsten Jahren an seinem Empfängerstandort somit abhängig vom Land und der TV-Senderegion eine Nutzung verschiedener terrestrischer Funkdienste vorfinden. Während an bestimmten Nutzungsorten für einen Fernsehempfänger bereits Nicht-Rundfunk-Dienste in einem oder in beiden Frequenzunterbändern arbeiten, muss der gleiche Typ eines Fernsehempfängers an anderen Empfängerstandort noch problemlos den Empfang und die Wiedergabe von TV-Diensten ermöglichen. Infolge der oben beschriebenen offenen und regional verschiedenen Zeitplanung bezüglich des Umsetzens der genannten digitalen Dividenden entsteht für einen Geräteentwickler beim Konzeptionieren des Eingangskreises eines TV-Empfangsteils somit eine kaum planbare Situation.

Während die beiden Fernsehrundfunkarten DVB-T und DVB-C so konzipiert wurden, dass zwischen ihnen keine Verträglichkeitsprobleme bestehen, fehlen bisher für den bidirektionalen Mobilfunk entsprechende Regelungen zum Vermeiden von Verträglichkeitsproblemen mit dem am Empfangsort aktiven Fernsehrundfunk. Eine zeitgleiche gemeinsame Nutzung von TV-Diensten und Mobilfunkdiensten am gleichen Empfangsort erfordert daher wegen zu erwartender Interferenzerscheinungen einen entsprechenden technischen Zusatzaufwand zum Realisieren einer Verträglichkeit zwischen den Diensten verschiedener Dienstarten.

Unabhängig vom Mobilfunk-Betrieb in einem der genannten Frequenzunterbänder werden jedoch die verbleibenden TV-Kanäle bis zum höchsten zugelassenen TV-Kanal des Rundfunkbandes V und somit bis zum unteren Ende des 800-MHz-Bandes bzw. des 700-MHz-Bandes ohne Einschränkung zumindest regionsabhängig für Fernsehrundfunk nutzbar sein.

Folglich können Konflikte mit Nicht-Rundfunk-Diensten wie Mobilfunknetzen in Regionen mit terrestrischem Fernsehrundfunk entstehen: Wobei sich der Konflikt nicht nur auf die unmittelbar benachbarten Kanäle beschränkt. Beispielsweise kann auch eine Übersteuerung des Empfängers durch LTE den Fernsehempfang in mehreren TV-Kanälen verhindern.

Darüber hinaus sind TV-empfängerseitige Funktionsstörungen durch die Multiträger-Signale von LTE-Sendern zu erwarten. Einerseits lässt der oben dargestellte geringere Frequenzabstand von gepulst sendenden Basisstationen zum genutzten TV-Kanal einen Einfluss auf den Fernsehempfang erwarten (Nachbarkanalstörungen), andererseits führt jedoch ein in der Regel größerer lokaler Abstand zwischen dem Empfangsort und den Basisstationen dazu, dass die Sendefeldstärken von Basisstationen am Empfangsort kleiner sein können als die Sendefeldstärke eines mobilen Endgerätes, das im gleichen Gebäude in sehr geringer Entfernung vom TV-Empfangsteil betrieben wird. Folglich sind trotz eines größeren Frequenzabstandes auch Einflüsse durch mobile Endgeräte auf den TV-Empfang nicht zu verhindern, beispielsweise durch Übersteuerung bzw. Sättigung des Eingangskreises im Rundfunkempfänger.

Neben der hohen Sendefeldstärke bei geringem Abstand zwischen dem mobilen Endgerät und dem TV-Empfangsteil führt auch ein stochastisches Auftreten des LTE-Sendespektrums des mobilen Endgerätes und dessen Intensitätsteuerung, insbesondere die Zeitvarianz des Mobilfunksignals, zu TV-Empfangsstörungen.

Somit kann sowohl Störleistung aus den Sendespektren der Basisstationen als auch aus den mobilen Endgeräten, beispielsweise direkt über die TV-Antenne beziehungsweise vom Kabelfernsehnetz oder über unzureichend geschirmte Anschlusskabel, zum Eingangskreis des TV-Empfangsteils gelangen.

Um den genannten Einfluss anderer Funkdienste in den genannten Frequenzunterbändern auf den DVB-Empfang zu verringern, ist es bekannt, ungewollt empfangene Störleistung selektiv durch sperrende Eingangsfiltermittel am Signaleingang des TV-Empfangsteils zu unterdrücken. Die Eingangsfiltermittel besitzen ein Tiefpassverhalten, welches oberhalb des angrenzenden Frequenzunterbandes die Eingangsleistung aller empfangenen Sendespektren drastisch dämpft. Derartige Eingangsfiltermittel realisieren beispielsweise bis zur Obergrenze von TV-Kanal 60 bei f_{Tu} = 790 MHz eine sehr geringe Einfüge-Dämpfung und darüber hinaus einen steilen Dämpfungsanstieg zu einer möglichst hohen Sperrdämpfung.

Ein Problem mit dem Eingangsfiltermittel entsteht jedoch dadurch, dass zur Kapazitätssteigerung von Kabelfernsehnetzen diese bis zu einer Grenzfrequenz f_{Bu} = 862 MHz ausgebaut werden. Modern strukturierte Kabelfernsehnetze übertragen neben den digitalen TV-Diensten auch Daten für Internetzugänge übers Netz. Dabei werden Datenströme bevorzugt im Abwärtsbetrieb, jedoch nicht zwingend, in TV-Kanälen des Bandes V bis f_{Bu} = 862 MHz übertragen, wobei jedoch die Kabel-Kanalbelegung grundsätzlich dem Netzbetreiber obliegt. Im genannten Band V dürfen daher auch länder- und regionalabhängig TV-Dienste verteilt werden.

Nicht nur aus dem letztgenannten Grund nutzen viele TV-Empfangsteile für terrestrisches und Kabelfernsehen eine gemeinsame Abstimmeinheit, welche über einen einzigen Signaleingang DVB-T- und DVB-C-Fernsehempfang umschaltfrei ermöglicht. Am Eingangskreis der gemeinsamen Abstimmeinheit kann alternativ entweder eine terrestrische TV-Antenne oder direkt ein digitales Kabelfernsehnetz angeschlossen werden. Somit müssen unabhängig vom Status der oberen Einschränkung des UHF-TV-Bandes die Abstimmeinheiten von TV-Empfangsteilen auch noch weiterhin die obere Grenzfrequenz des UHF-Bandes V bis f_{Bu} = 862 MHz und somit auch die Frequenzunterbänder einschließen.

Eine Studie des Fraunhofer Instituts für Nachrichtentechnik, Heinrich-Hertz-Institut, Berlin, vom 05.05.2009, mit dem Titel: "Aspekte der optimalen Nutzung der Digitalen Dividende in Deutschland" stellt verschiedene Beeinflussungsarten zwischen den digitalen Funkdiensten im 800-MHz-Band mit einer digitalen Mehrträger-Modulation OFDM arbeitenden Mobilfunknetzes ,UMTS Long Term Evolution' LTE auf die TV-Kanäle 55 bis 60 dar. Die genannten Störursachen des Breitband-Mobilfunknetzes beim Fernsehempfang sind:
- Mischungen dritten Grades und geringere Empfängerempfindlichkeit in Folge von nicht-korreliert modulierter Mobilfunk-Sendeleistung
- eine geringe Kanalselektion der HF-Eingangsschaltung in Folge einer Sättigung des Eingangsverstärkers im TV-Empfangsteil
- der Empfang eines Mobilfunksignals auf einer Spiegelfrequenz, welche durch den sporadischen Sendebetrieb von Mobilfunk-Endgeräten schwer beherrschbar ist.

Die Studie kommt zum Schluss; dass Eingangsfiltermittel mit einer hohen Flankensteilheit oberhalb von f_{Tu} = 790 MHz ein Eindringen von Mobilfunk-Sendeleistung in den Eingangskreis von TV-Empfangsteilen vermeiden können. Auch das Spiegelfrequenzproblem kann eingangsseitig mit einem entsprechenden Eingangsfilter gelöst werden.

Die obengenannten Frequenzplanungen erfolgen zwar international, aber die konkrete zeitliche Umsetzung der Planung liegt in der nationalen Verantwortung. Dadurch entsteht ein Problem für die Fernsehempfänger-Hersteller. Im Herstellungsprozess kann nicht berücksichtigt werden, ob und wann am zukünftigen Empfangsort die dargestellte gemeinsame Nutzung mit Nicht-Rundfunk-Diensten im vollen Umfang wirksam wird. Insbesondere können im Herstellungsprozess die folgenden Alternativen für lokalbedingte Empfangssituationen am Empfangsort nur schwer berücksichtigt werden:
- Eine erste lokale Empfangssituation betrifft Regionen ohne einen Sender für einen TV-Dienst in einem der genannten Frequenzunterbänder.
- Eine zweite lokale Empfangssituation betrifft Regionen mit einem terrestrischen TV-Sender im 800-MHz-Band oder den Anschluss des TV-Empfangsteils an einem Kabelfernsehnetz, das mindestens einen TV-Kanal im 800-MHz-Band für einen TV-Dienst nutzt.

Für die erste lokale Empfangssituation ist eine starke Eingangsfilterung oberhalb einer Grenzfrequenz von f_{Tu1} = 790 MHz bzw. gegebenenfalls später oberhalb von f_{Tu2} = 694 MHz vorteilhaft, welche am Empfangsteileingang den Eintritt von Sendeleistung aus dem von Sendespektren aller Funkdienstarten dämpft. Dafür werden sperrende Eingangsfiltermittel mit einem steilen Flankenanstieg oberhalb der unteren Grenzfrequenz des entsprechenden Frequenzunterbandes benötigt. Darüber hinaus ist im Interesse einer hohen Empfindlichkeit für alle TV-Kanäle bis zum TV-Kanal 60 eine möglichst geringe Einfüge-Dämpfung der Eingangsfiltermittel wünschenswert. Derartige Filter sind als passive Bauelemente bereits verfügbar und können vom Empfängernutzer selbst über lösbare HF-Verbindungen in den Signalweg zum TV-Empfangsteil eingefügt werden.

Die zweite lokale Empfangssituation erfordert einen möglichst ungedämpften Empfang aller TV-Dienst-Sendespektren einschließlich der TV-Dienste im entsprechenden Frequenzunterband. Das beschriebene eingefügte passive Filter wirkt somit den Forderungen der zweiten Empfangssituation entgegen.

In einem Kabelfernsehnetz ist noch zu beachten, dass die für DVB-C verwendeten Modulationsarten gegenüber DVB-T eine vergleichsweise geringe Störtoleranz aufweisen. Ein Einstrahlen von terrestrischen Funkdiensten in ein fehlerhaft installiertes oder unzureichend geschirmtes Kabelnetz lässt also besonders Störeinflüsse auf DVB-C-Transportströme erwarten.

Da bei der Empfängerfertigung weder die vorliegende Empfangssituation am späteren Empfangsort noch der Nutzungsstatus der entsprechenden Frequenzunterbänder mit Nicht-Rundfunk-Diensten bekannt ist, kann praktisch im Eingangskreis kein fest konfiguriertes Eingangsfiltermittel zur Lösung des dargestellten Problems verwendet werden. Insbesondere fehlt zum Konfigurieren des Eingangsfilters Information zum Vorhandensein und der Intensität von Sendespektren von regional betriebenen Mobilfunkdiensten beziehungsweise zum Anschluss an ein Kabelfernsehnetz und dessen Kanalstruktur.

Ein Anpassen des Dämpfungsverhaltens des Eingangsfiltermittels an die lokale Empfangssituation wäre einem Empfängernutzer mangels Kenntnisse zu den Interaktionen der beiden Funkdienstarten am Empfangsort kaum zuzumuten. Diese würde einen weniger wünschenswerten Mehraufwand beziehungsweise Sachkenntnis bei der Einstellung erfordern.

Es sind auch Lösungen zum automatischen Erkennen von Sendespektren empfangener Funkdienste bekannt. Diese identifizieren bei einem automatischen Sendersuchlauf entdeckte Sendespektren anhand eines vom TV-Empfangsteil auswertbaren modulierten HF-Eingangssignals. Zur eindeutigen Identifikation des Funkdienstes an Hand seines Sendespektrums sind verschiedene Auswertkriterien bekannt. Beispielsweise kann die Häufigkeit von Bitfehlern, die Bitfehlerrate, an einem Demodulator-Ausgang zum Erkennen eines digital kodierten DVB-Spektrums herangezogen werden. Integrierte digitale Demodulator-Schaltungen weisen deshalb häufig einen Statusmonitor auf, der den Einrastzustand der Fehlerkorrektur anzeigt.

So beschreibt das europäische Patent EP 0687028B1 eine Ausrichtvorrichtung für eine Satellitenempfangsantenne von digitalen TV-Dienste, bei welcher der Empfangsteil-Demodulator eine Steuerinformation ausgibt, wenn dieser auf einer gültigen Abstimmfrequenz eine gültigen Datenrate findet und bei dem eine digitale Fehlerkorrektur anhand einer iterativen Messung der Bitfehlerrate möglich ist.

Der Druckschrift US 2011/212698 A1 lässt sich ein System und ein Verfahren entnehmen, die eine adaptive Filterung von Hochfrequenzsignalen (RF-Signalen) bereitstellen. Mehrere Signale werden in einem vorbestimmten HF-Spektrum empfangen, wobei die Signale ein gewünschtes Signal und mehrere potentiell interferierende Signale enthalten. Ein erstes Signal der potentiell störenden Signale wird in ein Basisbandsignal herunterkonvertiert und eine Leistung des Basisbandsignals bestimmt. Wenn die Leistung eine vorbestimmte Schwellenleistung überschreitet, wird ein erstes Kerbfilter (o.a. Bandsperre; vgl. https://de.wikipedia.org/wiki/Kerbfilter), das einer Frequenz des ersten Signals entspricht, aktiviert.

Die WO 03/092160 A1 offenbart ein System, eine Vorrichtung und / oder ein Verfahren. Es wird eine Frequenzantwortanpassung eines HF-Eingangsfilters eines HF-Tuners gezeigt, basierend auf der Impedanz eines Antennensystems, das den Empfang von HF-Signalen an den HF-Tuner bereitstellt. Die Frequenzganganpassung erfolgt vorzugsweise dynamisch und / oder mit Bezug auf jede abgestimmte Frequenz. Insbesondere stellt das System, das Verfahren und / oder die Vorrichtung eine Kompensation auf der HF-Tuner-Ebene für Verstimmungseffekte bereit, die auf dem HF-Tuner durch eine Antennensystemimpedanz erzeugt werden, die an dem Antenneneingang, der anders als ein für eine Impedanz entworfen ist, präsentiert ist.

### Darstellung der Erfindung

Der vorliegenden Patentanmeldung liegt die Aufgabe zugrunde, in einem TV-Empfangsteil enthaltene Eingangsfiltermittel für terrestrische und/oder über Kabel verteilte TV-Dienste an eine regionalbedingte aktuelle Empfangssituation anzupassen.

Abhängig von der Empfangssituation am Empfangsort sind Eingangsfiltermittel zu schaffen, welche Interferenzen aus einem zeitgleichen Sendebetrieb verschiedener Funkdienstarten, wie TV-Dienste und bidirektionale Funkdienste, in einem am Empfangsort gemeinsam genutzten Frequenzunterband minimieren. Insbesondere soll jedes nachträgliche manuelle Anpassen der Eingangsfiltermittel am Empfangsort an eine sich ändernde Empfangssituation vermieden werden.

Der Gegenstand der vorliegenden Patentanmeldung geht von einem TV-Empfangsteil für terrestrische und/oder über Kabel verteilte TV-Dienste mit einem definierten Empfangsbereich aus, das eine Steuereinrichtung mit Permanentspeichermitteln und Eingangsfiltermittel zum frequenzselektiven Unterdrücken von Sendeleistung aus Sendespektren eines Frequenzunterbandes aufweist, welche den Zugang von Sendeleistung aus dem entsprechenden Frequenzunterband zu einem Eingangskreis einer Abstimmeinheit des TV-Empfangsteils dämpfen.

Die Eingangsfiltermittel sind so bemessen, dass diese den definierten Empfangsbereich des TV-Empfangsteils zumindest teilweise im Frequenzunterband einschränken, wobei das Frequenzunterband in einer Empfangsregion für verschiedene Funkdienstarten gemeinsam zeitgleich nutzbar und innerhalb eines Rundfunkbandes eingeschlossen ist.

Zur Lösung der Aufgabe enthält das TV-Empfangsteil gemäß der vorliegenden Anmeldung Analyseroutinen, welche die folgenden Merkmale aufweisen:
- Die Steuereinrichtung führt im Zusammenwirken mit der Abstimmeinheit Sendersuchläufe im Frequenzunterband zum Auffinden von Sendespektren aus.
   - Erkennungsmittel für eine Dienstarterkennung bestimmen im Ergebnis eines Sendersuchlaufs die aktuelle Empfangssituation in der Empfangsregion anhand eines für selektierte Sendespektren benutzten Übertragungsstandards.
   - Die Steuereinrichtung steuert die Eingangsfiltermittel abhängig von der aktuellen Empfangssituation in der Empfangsregion alternativ in Einstellzuständen, die einen Durchlasszustand beziehungsweise einen frequenzselektiven Sperrzustand umfassen.

Die Eingangsfiltermittel dämpfen im Sperrzustand möglichst stark für mindestens einen Teil eines Frequenzunterbandes den Sendeleistungszugang aus Sendespektren zum Eingangskreis. Im Gegensatz dazu weisen die Eingangsfiltermittel im Durchlasszustand eine geringe Einfüge-Dämpfung auf, um möglichst alle TV-Sendespektren, insbesondere auch die außerhalb eines Frequenzunterbandes, ohne nennenswerte Empfindlichkeitseinbußen zu empfangen.

In einer erweiterten Ausführungsform der Erfindung enthält die Abstimmeinheit im Eingangskreis Anpassmittel, die verschiedene Einstellzustände aufweisen, welche die Steuereinrichtung zum Anpassen der Eingangsempfindlichkeit und/oder Signalrobustheit an die aktuelle Empfangssituation in der Empfangsregion nutzt.

Vorteilhaft sind die Anpassmittel im Eingangskreis ein Vorverstärker, der zwischen einem Verstärkermodus und einem Bypass-Modus umschaltbar ist.

Gemäß der Erfindung kann die Steuereinrichtung im Zusammenwirken mit der Abstimmeinheit und den Erkennungsmitteln verschiedene Analyseroutinen nach Sendespektren im Rundfunkband ausführen, um für jeden verfügbaren TV-Dienst den optimalen Einstellzustand der Eingangsfiltermittel zwischen dem Durchlasszustand und dem frequenzselektiven Sperrzustand zu bestimmen.

Eine Bandanalyseroutine führt mit der Abstimmeinheit einen Sendersuchlauf in mindestens einem Frequenzunterband nach Sendespektren aus, während sich die Eingangsfiltermittel im Durchlasszustand befinden. Die Steuereinrichtung überwacht den Sendersuchlauf mit den Erkennungsmitteln, welche jeweils im abgesuchten Frequenzunterband auf empfangene Sendespektren mit Medieninhalt eines TV-Dienstes reagieren.

Der Sendersuchlauf hat zur Folge, dass die Abstimmeinheit unabhängig von den Funkdienstarten alle Sendespektren innerhalb des jeweils abgesuchten Frequenzunterbandes findet und nacheinander an einem Signalausgang für die Erkennungsmittel zum Erkennen der Dienstart bereitstellt.

Sofern die Dienstarterkennungsmittel im abgesuchten Frequenzunterband keine Sendespektren mit Medieninhalt eines TV-Dienstes entdecken, setzt die Steuereinrichtung die Eingangsfiltermittel in den frequenzselektiven Sperrzustand. Auf diese Weise sind auch außerhalb des entsprechenden Frequenzunterbandes verfügbare TV-Sendespektren vor Störeinwirkungen durch Sendespektren anderer Dienstarten besser geschützt. Mit diesem Einstellzustand der Eingangsfiltermittel bietet das TV-Empfangsteil insbesondere auch einen hohen Schutz gegen Funkstörungen aus der Aufwärtsanbindung von mobilen Endgeräten, welche zu nahe am Empfängerstandort senden. Da solche Funkstörungen nur sporadisch und sehr kurzzeitig auftreten können, wäre eine Bandanalyseroutine, welche nach Sendespektren von Mobilfunkdiensten sucht, zeitaufwändig, bezüglich von zusätzlich benötigten Erkennungsmitteln aufwändig und bezüglich des Auffindens und Erkennens von Mobilfunkdiensten relativ unsicher.

Im Gegensatz dazu lässt die Steuereinrichtung die Eingangsfiltermittel in den Durchlasszustand, sofern die Erkennungsmittel im abgesuchten Frequenzunterband mindestens ein TV- Sendespektrum erkennen, um einen uneingeschränkten Empfang aller TV-Dienste im genutzten Rundfunkband zu ermöglichen.

Dieser Maßnahme liegt die Erkenntnis zugrunde, dass innerhalb der Empfangsregion im abgesuchten Frequenzunterband entweder aktuell keine anderen Funkdienstarten als der erkannte TV-Dienst verfügbar sind oder dass die Dienste anderer Funkdienstarten im abgesuchten Frequenzunterband eigene Maßnahmen, wie eine strenge Pegelkontrolle und eine steile Spektralfilterung am Senderausgang, ergriffen haben, um Interferenzen mit Sendespektren von TV-Sendern zu reduzieren.

Gemäß einer alternativen Ausführungsform der Erfindung identifiziert die Steuereinrichtung von den Erkennungsmitteln entdeckte TV-Dienste, die innerhalb des Frequenzunterbandes senden, und trägt diese TV-Dienste entsprechend markiert in die Permanentspeichermittel ein. Arbeitet das Empfangsteil im Wiedergabemodus, hebt die Steuereinrichtung die Dämpfung der Eingangsfiltermittel nur solange auf, wie die Abstimmeinheit auf einen markierten TV-Dienst, das heißt einen in einem Frequenzunterband arbeitenden TV-Dienst, abgestimmt ist. Wird dagegen die Abstimmeinheit auf einen unmarkierten TV-Dienst abgestimmt, bleiben die Eingangsfiltermittel im Sperrzustand. Sendespektren aus dem entsprechenden Frequenzunterband werden damit bis auf die genannte Ausnahme im Wiedergabemodus des TV-Empfangsteils grundsätzlich gedämpft.

Mit dieser Art der Filtersteuerung kann, wie oben beschrieben, der Fernsehempfang von TV-Diensten mit einem Sendespektrum außerhalb der Frequenzunterbänder wirksamer vor Störeinflüssen durch Nicht-Rundfunk-Dienste geschützt werden. Diese Maßnahme verbessert insbesondere einerseits den Schutz gegen Funkstörungen aus der Aufwärtsanbindung von mobilen Endgeräten, welche zu nahe am Empfängerstandort senden, und ermöglicht andererseits den Empfang eines im Frequenzunterband aktiven TV-Dienstes.

Nach einer vorteilhaften Fortführung der Erfindung wertet eine Kanalanalyseroutine mithilfe der Steuereinrichtung und den Erkennungsmitteln alternative Einstellzustände für die Eingangsfiltermittel und/oder den Anpassmitteln im Eingangskreis aus, während die Abstimmeinheit auf einen TV-Kanal abgestimmt ist, um für TV-Dienste mit außerhalb des Frequenzunterbandes liegenden Sendespektren kanalbezogen jeweils einen individuellen Einstellzustand für die Eingangsfiltermittel und/oder den Anpassmitteln zu bestimmen.

Die Kanalanalyseroutine kann im Wiedergabemodus des Empfangsteils bei jedem Wechsel zu einem anderen TV-Dienst gestartet werden. Dabei wechselt die Steuereinrichtung den aktuellen Einstellzustand für die Eingangsfiltermittel und/oder der Anpassmittel entsprechend den von der Kanalanalyseroutine ermittelten und in den Permanentspeichermitteln gespeicherten Einstellzuständen zum aktuell eingestellten TV-Kanal.

Die Kanalanalyseroutine erfordert einen kaum spürbaren Zeitaufwand und kann auch periodisch während des Wiedergabemodus eines TV-Dienstes durchgeführt werden. Auf diese Weise kann die Steuereinrichtung dynamisch auf sich ändernde Aktivitäten von störenden Funkdiensten im Frequenzunterband reagieren und effektiver auch temporär auftretende Störquellen, wie den sporadischen Sendebetrieb eines mobilen Endgerätes, kompensieren.

Nach einer vorteilhaften Fortführung der Erfindung definiert die Kanalanalyseroutine unter einem Zusammenwirken der Steuereinrichtung mit Fehlererkennungsmitteln jeweils kanalbezogen den individuellen Einstellzustand. Dabei steuert die Steuereinrichtung sowohl die Eingangsfiltermittel als auch die Anpassmittel aufeinanderfolgend in die alternativen Einstellzustände und die Fehlererkennungsmittel vergleichen die Empfangsqualitäten des mit der Abstimmeinheit eingestellten TV-Dienstes in Abhängigkeit von den Einstellzuständen der Eingangsfiltermittel. Das Ergebnis des Vergleichs wird in den Permanentspeichermitteln abgelegt, um bei jedem Aufruf zum Empfangen eines solchen TV-Dienstes die Eingangsfiltermittel in den entsprechend definierten Einstellzustand zu steuern.

Zum Anpassen der Eingangsfiltermittel in einem TV-Empfangsteil für terrestrische und/oder über Kabel verteilte TV-Dienste an eine aktuelle Empfangssituation in einer Empfangsregion gemäß der Aufgabe der Erfindung dient am Aufstellort des Empfangsteils das nachfolgend beschriebene Arbeitsverfahren.

Die Steuereinrichtung im TV-Empfangsteil enthält eine Steuersoftware, welche zumindest bei der Inbetriebnahme des TV-Empfangsteils am Aufstellort im Zusammenwirken mit den Eingangsfiltermitteln, der Abstimmeinheit und Erkennungsmitteln Analyseroutinen zum Bestimmen der aktuellen Empfangssituation in der Empfangsregion und zum Anpassen der Eingangsfiltermittel ausführt. Die Analyseroutinen umfassen die folgenden Verfahrensschritte:
- Eine Steuereinrichtung führt mit der Abstimmeinheit Sendersuchläufe zum Auffinden von Sendespektren aus.
- Erkennungsmittel für Dienstarten bestimmen im Ergebnis eines Sendersuchlaufes die aktuelle Empfangssituation in der Empfangsregion durch Auswerten des Medieninhalts der Sendespektren.
- Die Steuereinrichtung steuert abhängig von einer aktuellen Empfangssituation in der Empfangsregion sowohl die Eingangsfiltermittel als auch die Anpassmittel in Einstellzustände.

Die Steuersoftware startet eine Analyseroutine, insbesondere die oben dargestellte Bandanalyseroutine, automatisch im Verbund mit einem Sendersuchlauf, bei dem beispielsweise der Inhalt Programmspeicher an den Umfang von lokal verfügbaren TV-Diensten anzupassen ist. Da sich nicht nur das Angebot von aktiven TV-Diensten sondern auch die Nutzung des Frequenzunterbandes ständig ändert, sollte vorteilhaft die Bandanalyseroutine periodisch in Abständen von Wochen oder Monaten automatisch gestartet werden.

Weitere Routinen, insbesondere die oben dargestellte Kanalanalyse, sollen vorteilhaft zumindest bei jedem Einschalten des TV-Empfangsteils oder bei jedem Wechsel des vom Gerätenutzer ausgewählten Transportmultiplex automatisch gestartet werden. Da die Kanalanalyse nahezu unbemerkt abläuft, kann diese während des Wiedergabemodus bei jedem Umschalten zu einem anderen TV-Dienst oder jedem Absinken der Empfangsqualität unter einem Mindestwert automatisch ausgeführt werden.

Die beschriebene Lösung realisiert somit ein selbstkonfigurierendes Eingangsfiltermittel, bei dem die Steuereinrichtung des TV-Empfangsteils mithilfe von Suchläufen und Analyseroutinen in Abhängigkeit vom Betrieb verschiedener Funkdienstarten im Frequenzunterband am Empfangsort die aktuelle Empfangssituation bestimmt und die Eingangsfiltermittel entsprechend den Fortschritten bei der nationalen Umsetzung der beschlossenen Reduzierung des TV-Bandes V dynamisch anpasst.

### Bevorzugte Ausführung der Erfindung

Die vorliegende Erfindung soll anhand von Ausführungsbeispielen erläutert werden. Die nachfolgenden Darstellungen betreffen Ausführungsformen der Erfindung, die zur Erläuterung des Prinzips gemäß der Erfindung dienen. Der Fachmann kann zur Umsetzung des mit den Patentansprüchen beanspruchen technischen Gegenstandes, natürlich die Komponenten des TV-Empfangsteils, insbesondere das Eingangsfilter oder die Erkennungsmittel für Dienstarten, ändern.

Zur besseren Veranschaulichung dienen die beigefügten Figuren 1 bis 5, welche im Einzelnen zeigen:
- FIG. 1: ein Prinzip-Schaltbild für ein an die aktuelle Empfangssituation in der Empfangsregion anpassbares TV-Empfangsteil zum Empfangen von TV-Diensten sowohl über terrestrischen Fernsehrundfunk DVB-T als auch über Kabelfernsehen DVB-C,
- FIG. 2a: eine weitere Ausführungsform des TV-Empfangsteils gemäß der Erfindung mit einer erweiterten Einstellmöglichkeit zum Anpassen an die aktuelle Empfangssituation in der Empfangsregion zum Unterdrücken eines Frequenzunterbandes mit einem einzigen Filter,
- FIG. 2b: eine alternative Ausführungsform des TV-Empfangsteils gemäß FIG. 2a mit einem Eingangsfilter, das zum Unterdrücken mehrerer Frequenzunterbänder verschiedene Sperrfilter aufweist,
- FIG. 3: ein Ablaufschema zur Funktion einer Bandanalyseroutine zum Erkennen von aktiven TV-Diensten in einem Frequenzunterband,
- FIG. 4: ein Ablaufschema zur Funktion einer Kanalanalyseroutine zum Erkennen von Störungen beim Empfangen von ausgewählten TV-Diensten und
- FIG. 5: ein in seiner Darstellungsform verkürztes Ablaufschema einer erweiterten Ausführung der Kanalanalyseroutine nach FIG. 4.

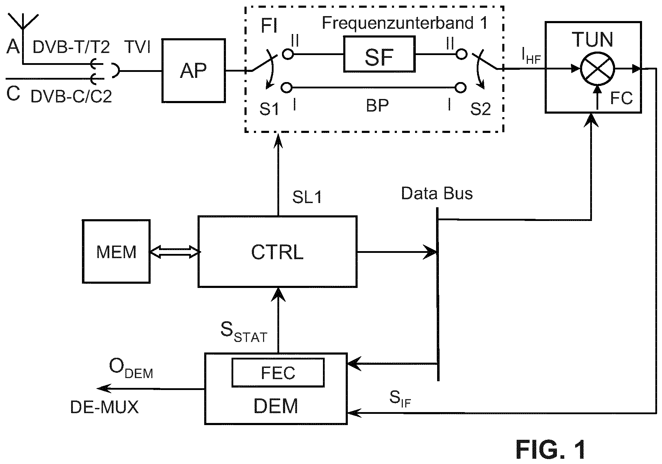

FIG. 1 zeigt das TV-Empfangsteil mit einer herkömmlichen abstimmbaren HF-Abstimmeinheit TUN, einer Demodulator-Einheit DEM und einer Steuereinrichtung CTRL. Die HF-Abstimmeinheit TUN, auch als TV-Rundfunktuner bezeichnet, ist für den Empfang von trägerfrequenten Signalgemischen, den Sendespektren, bis zu einer Empfangsbereichs-Obergrenze, beispielsweise dem TV-Kanal 69 bei einer oberen Grenzfrequenz f_{T} = 862 MHz, ausgelegt. An einem geschirmten Eingangsanschluss TVI können wahlfrei entweder die trägerfrequenten Signalgemische von einer terrestrischen Antenne A digital modulierte Fernsehträgersignale DVB-T beziehungsweise DVB-T2 oder auch aus einem Breitbandkabelfernsehnetz über ein Verbindungskabel C unter anderem digital modulierte Kabelfernsehsignale DVB-C beziehungsweise DVB-C2 in einen Eingangskreis I_{HF} der HF-Abstimmeinheit TUN eingespeist werden. Die HF-Abstimmeinheit TUN enthält einstellbare Kanalselektionsfilter, mit denen ein Empfängernutzer in einem Wiedergabemodus über die Steuereinrichtung CTRL einen TV-Kanal auswählt, welcher in seinen Trägerwellen den Signalmultiplex mit einem gewünschten DVB-Dienst trägt, und einen Frequenzumsetzer FC, der das ausgewählte Sendespektrum unabhängig von der Trägerfrequenzlage in eine feste Zwischenfrequenzlage umsetzt. Dabei gelangt zum Signaleingang der Demodulator-Einheit DEM ein umgesetztes Sendespektrum S_{IF} von einem modulierten Transportstrom, welcher neben weiteren DVB-Diensten auch den Programminhalt des gewünschten DVB-Dienstes trägt.

Die Demodulator-Einheit DEM gewinnt DVB-Dienst-Daten aus einem DVB-Transportmultiplex zurück und enthält unter anderem Einstell-, Steuer-, Synchronisations- und Signalisiermittel sowie eine integrierte Fehlerkorrekturschaltung FEC, den Viterbi-Decoder. Die Fehlerkorrekturschaltung FEC enthält einen Statusausgang S_{STAT} für eine Signalisierung, welche anzeigt, ob das von der HF-Abstimmeinheit TUN umgesetzte Sendespektrum S_{IF} regenerierbare DVB-Dienst-Daten enthält.

Vorteilhaft ist die Demodulator-Einheit DEM an die DVB-Wege DVB-T und DVB-C anpassbar und realisiert Modulationsverfahren wie Quadraturamplitudenmodulation QAM, Orthogonal Frequency Division Multiplex OFDM und Coded Orthogonal Frequency Division Multiplex COFDM und die entsprechenden im TV-Kanal genutzten Fehlerkorrekturverfahren.

Idealerweise enthält die Demodulator-Einheit DEM entsprechende Demodulatoren für die Übertragungswege DVB-T, DVB-T2, DVB-C und DVB-C2, sodass das Signal von Statusausgang S_{STAT} unabhängig vom DVB-Weg und dem benutzten Modulationsverfahren signalisiert, wenn das umgesetzte Sendespektrum S_{IF} am Signaleingang der Demodulator-Einheit DEM einem DVB-Dienst zuzuordnen ist. Auf diese Weise realisiert die komplexe Demodulator-Einheit DEM ohne zusätzlichen Aufwand im Zusammenwirken mit der Abstimmeinheit TUN die beanspruchten Erkennungsmittel zum Erkennen von Dienstarten in ausgewählten TV-Kanälen.

Das demodulierte Sendespektrum eines ausgewählten TV-Dienstes verlässt die Demodulator-Einheit DEM in Richtung zu einem nichtdargestellten De-Multiplexer DE-MUX des TV-Empfangsteils am Ausgang O_{DEM}.

Die Signalisierung kann, wie in FIG. 1 gezeigt, vom Statusausgang S_{STAT} über eine separate Verbindung oder auch über einen bekannten Datenbus zur Steuereinrichtung CTRL, welche vorteilhaft in der konventionellen Gerätesteuerung des TV-Empfangsteils integriert ist, gesendet werden. Die Steuereinrichtung CTRL verwaltet mittels Permanentspeichermittel MEM eine Empfängerdatenbank mit Einstellparametern zum Rückgewinnen von verfügbarem DVB-Dienst-Inhalt, wie die Einstellparameter für die Abstimmeinheit TUN und die Modulationsparameter für die Demodulator-Einheit DEM, und steuert beide Einheiten über den Datenbus.

Soweit bis hier ausgeführt wurde, unterscheidet sich der Inhalt der Empfängerdatenbank mit Einstellparametern nicht vom Datenbankinhalt eines herkömmlichen TV-Empfangsteils.

Dem Eingangsanschluss TVI zum Eingangskreis I_{HF} der HF-Abstimmeinheit TUN folgt gemäß der Erfindung ein über die Steuereinrichtung CTRL elektronisch steuerbares Eingangsfilter FI, welches einen Sperrfilter SF aufweist, das zwischen elektronisch einstellbaren HF-Umschaltern S1 und S2 eingebettet ist.

Die HF-Umschalter S1, S2 stellen mit Schaltpositionen I und II alternative Einstellzustände für das Eingangsfilter FI bereit. Dabei realisiert die Schaltposition I über eine Bypassverbindung BP eine direkte und damit im Empfangsfrequenzbereich uneingeschränkte Verbindung, wogegen Schaltposition II eine Verbindung über das Sperrfilter SF zum Eingangskreis I_{HF} realisiert, welche in einem frequenzselektiven Sperrzustand nur einen Empfang mit einem eingeschränkten Empfangsfrequenzbereich zulässt. Die Schaltposition I entspricht damit dem uneingeschränkten Durchlasszustand des Eingangsfilters FI, während die Schaltposition I dem frequenzselektiven Sperrzustand des Eingangsfilters FI entspricht.

Die HF-Umschalter S1, S2 sind beispielsweise integrierte Halbleiterschaltungen, welche je nach Ausführung, wie FIG. 1 zeigt, von der Steuereinrichtung CTRL über eine Steuerleitung SL1 oder über den Datenbus gesteuert werden.

Um im Wiedergabemodus das Empfangsverhalten, insbesondere die Eingangsempfindlichkeit, des TV-Empfangsteils für verfügbare TV-Dienste im eingeschränkten Empfangsfrequenzbereich möglichst wenig über die Filtercharakteristik des Sperrfilters SF zu beeinflussen, soll einerseits das Sperrfilter SF bis zum angrenzenden TV-Kanal vor dem zu dämpfenden Frequenzunterband 1 einen Durchlasszustand mit einer möglichst geringen Einfüge-Dämpfung aufweisen. Andererseits soll das Sperrfilter SF zum Einschränken des Empfangsfrequenzbereiches mit einem möglichst steilen Übergang vom angrenzenden TV-Kanal zum frequenzselektiven Sperrzustand übergehen.

Das Sperrfilter SF in FIG.1 ist beispielsweise zum Dämpfen des 800MHz-Bandes ein Oberflächenwellenfilter, welches im für verschiedene Funkdienste gemeinsam nutzbaren Frequenzunterband 1 von 791 MHz bis mindestens 862 MHz die Filtercharakteristik einer Bandsperre besitzt.

Im Gegensatz dazu wäre zum Dämpfen der beiden Frequenzunterbänder 1 und 2, im Beispiel das 700MHz-Band und das 800MHz-Band, für das Sperrfilter SF eine Bandsperre mit einer Filtercharakteristik von etwa 791 MHz bis mindestens 862 MHz erforderlich.

Für den Gegenstand der Erfindung ist es unwesentlich, ob zum Dämpfen mehrerer Frequenzunterbänder 1 und 2 ein einziges Oberflächenwellenfilter oder eine Kombination aus mehreren Oberflächenwellenfiltern Anwendung findet.

Das Sperrfilter SF kann auch die Filtercharakteristik eines Tiefpasses höherer Ordnung mit einer Grenzfrequenz bis zum eingeschränkten Empfangsfrequenzbereich oder eine Kombination von Tiefpässen aufweisen, wobei eine Tiefpasskombination auch aus diskret schaltbaren Bandsperren bestehen kann. Damit lassen sich beispielsweise nur die Aufwärtsanbindung sowie die Abwärtsanbindung von Mobilfunkdiensten in den Frequenzbereichen von 801 bis 811 MHz bzw. von 841 bis 852 MHz unterdrücken.

Die Kombination aus mehreren schaltbaren Bandsperren hat den Vorteil, dass beispielsweise im Wiedergabemodus die Frequenzbereiche für die Aufwärtsanbindungen von 832 MHz bis 862 MHz und den Abwärtsanbindungen von 791 MHz bis 821 MHz der Mobilfunkdienste abhängig von der aktuellen Empfangssituation in der Empfangsregion separat gesperrt werden können. So kann beispielsweise bei einem unzureichend geschirmten Kabelfernsehanschluss nur der Einfluss der Aufwärtsanbindungen von in der Nähe des TV-Empfangsteils betriebener mobiler Endgeräte unterdrückt werden. Das hat den Vorteil, dass das TV-Empfangsteil im Wiedergabemodus an einem Kabelfernsehnetz mit der Schaltposition II auch jene Dienste, welche im Bereich der Abwärtsanbindungen oder der oben genannten Duplexlücke verbreitet werden, ohne nennenswerte Dämpfung durch das Sperrfilter SF empfangen kann.

In der Schaltposition II liegt das Sperrfilter SF im Eingangskreis I_{HF} und verringert die HF-Empfindlichkeit des TV-Empfangsteils für Sendespektren in einem gemeinsam nutzbaren Frequenzunterband. Die gedämpften Sendespektren haben somit nur noch einen minimalen Störeinfluss auf den Empfang von TV-Diensten im eingeschränkten Empfangsfrequenzbereich. Dieses reduziert wirksam Interferenzen und Intermodulationen zwischen beiden Funkdiensten.

Im Gegensatz dazu führt in der Schaltposition I die Bypass-Verbindung BP alle empfangbaren Sendespektren uneingeschränkt bis zum TV-Kanal 69 zum Eingangskreis I_{HF}. Da in der Schaltposition I alle Sendespektren möglichst unverzerrt in den Eingangskreis I_{HF} gelangen sollen, ist die Bypass-Verbindung BP als störstellenfreie Hochfrequenzverbindung auszuführen.

Gemäß der Erfindung bestimmt die Steuereinrichtung CTRL die aktuelle Empfangssituation in der Empfangsregion mit Erkennungsmitteln, welche die Dienstart von im Frequenzunterband liegenden Diensten erkennen. Die Steuereinrichtung CTRL führt dafür kanalweise eine weiter unten beschriebene Bandanalyseroutine mit einem Sendersuchlauf im Frequenzunterband aus. Das Eingangsfilter FI steht dabei in der Schaltposition I - Durchlasszustand. Die Steuereinrichtung CTRL nutzt für die Analyseroutine Einstellparameter, welche in einer Lookup-Tabelle für digitale TV-Dienste hinterlegt sind.

Der Vorteil der Erfindung besteht also darin, dass das in FIG. 1 beschriebene TV-Empfangsteil allein durch Ausführen eines Sendersuchlaufs in einem Frequenzunterband die aktuelle Empfangssituation in der Empfangsregion anhand eines für selektierte Sendespektren dadurch bestimmt, dass ein Absuchen und Prüfen der TV-Kanäle eines oder mehrerer Unterbänder mit der Demodulator-Einheit DEM ermittelt, ob am Empfangsort innerhalb der Empfangsregion in einem Frequenzunterband mindestens ein Sendespektrum von einem DVB-Dienst empfangbar ist.

In der in FIG. 1 dargestellten einfachsten Ausführungsform der Erfindung liegt zwischen dem Eingangsanschluss TVI und dem Eingangsfilter FI eine Anpassschaltung AP, welche die Hochfrequenz-Impedanzen der terrestrischen Antenne A beziehungsweise das Verbindungskabel C zum Breitbandkabelfernsehnetz an das Eingangsfilter FI wellentechnisch anpasst.

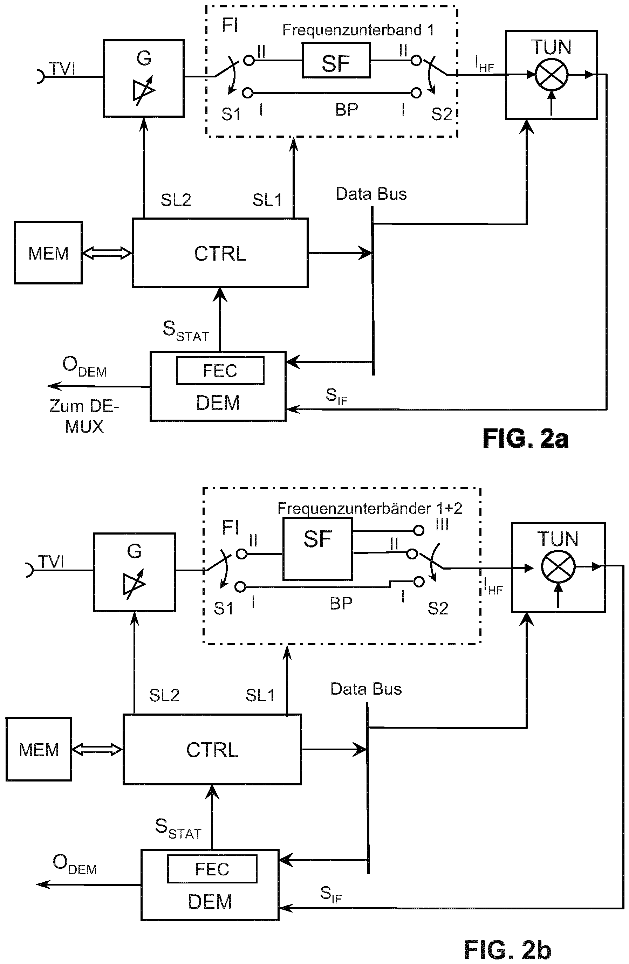

FIG. 2a zeigt eine erweiterte Ausführungsform eines TV-Empfangsteils gemäß der Erfindung. Die Ausführungsform enthält wie viele konventionelle TV-Empfangsteile als Anpassschaltung im Eingangskreis I_{HF} einen Vorverstärker G, dessen Verstärkungsfaktor geändert werden kann. Der Vorverstärker ist beispielsweise ein Breitbandverstärker mit einer oberen Grenzfrequenz bei 1000 MHz, der zwischen einem Verstärkermodus mit einem von etwa Gₚ = 10 dB und einem Bypass-Modus für HF-Signale umschaltbar ist.

Bei konventionellen TV-Empfangsteilen dient der aktivierte Verstärkermodus des Vorverstärkers G zum Kompensieren frequenzabhängiger Dämpfungsverluste im Eingangskreis I_{HF}, die mit höheren Trägerfrequenzen entstehen. Die Dämpfungsverluste entstehen beispielsweise durch einen Signalverteiler, welcher die modulierten Fernsehträgersignale im Eingangskreis I_{HF} auf mehrere HF-Abstimmeinheiten aufteilt, und beim vorliegenden TV-Empfangsteil durch die Einfüge-Dämpfung des Eingangsfilters FI. Ohne den Vorverstärker G sind bekanntlich für den Empfang und die Wiedergabe eines TV-Dienstes am Eingangsanschluss TVI der HF-Abstimmeinheit TUN höhere Empfangspegel der modulierten Fernsehträgersignale erforderlich. Das heißt, die Signalempfindlichkeit der HF-Abstimmeinheit TUN ist geringer, aber in vielen Fällen noch ausreichend. Andererseits müssen zum Stören des Empfangs und der Wiedergabe des TV-Dienstes auch die Empfangspegel der störenden Sendespektren höher sein; die Signalrobustheit gegenüber Störungen verbessert sich.

Gemäß der Erfindung kann die Steuereinrichtung CTRL den Vorverstärker G durch Wechsel zwischen dem Verstärkermodus und dem Bypass-Modus als Anpassmittel zum Anpassen der Eingangsempfindlichkeit an die aktuelle Empfangssituation in der Empfangsregion nutzen. Im Ausführungsbeispiel erfolgt ein Umschalten zwischen dem Verstärkermodus und dem Bypass-Modus über die Steuerleitung SL2. Der Verstärkermodus erhöht die Eingangsempfindlichkeit des TV-Empfangsteils zu Lasten der Störempfindlichkeit gegen unerwünschte Sendespektren. Im Gegensatz dazu: reduziert der Bypass-Modus die Eingangsempfindlichkeit des TV-Empfangsteils, erlaubt höhere Eingangspegel am Eingangsanschluss TVI der HF-Abstimmeinheit TUN und schafft eine bessere Störfestigkeit gegenüber von unerwünschten Sendespektren.

Da gemäß der Erfindung die Steuereinrichtung CTRL zum Anpassen der Eingangsempfindlichkeit an die aktuelle Empfangssituation in der Empfangsregion sowohl die Einstellzustände des Vorverstärkers G als auch die Einstellzustände des Eingangsfilters FI unabhängig voneinander ausführen kann, ergeben sich auf einfache Weise verschiedene Einstellstufen des TV-Empfangsteils.

Die nachfolgende Tabelle 1 gibt eine Übersicht über die verschiedenen Einstellstufen des TV-Empfangsteils zum Anpassen und deren Auswirkung beim Empfang und der Wiedergabe von TV-Diensten hinsichtlich des gemeinsamen Betriebs mit zusätzlichen Funkdienstarten.

**Tabelle 1**

| **EinstellStufe** | **Einstellzustand** | | **Wirkung** |
|---|---|---|---|
| | **Vorverstärker G** | Eingangsfilter FI | |
| 1 | Verstärkermodus | Durchlasszustand | hohe Signalempfindlichkeit; voller Empfangsfrequenzbereich; geringe Großsignalfestigkeit, somit geringe Störfestigkeit gegen zusätzliche Funkdienstarten |
| 2 | Verstärkermodus | Sperrzustand | hohe Signalempfindlichkeit; eingeschränkter Empfangsfrequenzbereich; daher bessere Störfestigkeit gegen zusätzliche Funkdienstarten; jedoch geringe Großsignalfestigkeit |
| 3 | Bypass-Modus | Durchlasszustand | geringe Signalempfindlichkeit; voller Empfangsfrequenzbereich; bessere Großsignalfestigkeit, daher bessere Störfestigkeit gegen zusätzliche Funkdienstarten |
| 4 | Bypass-Modus | Sperrzustand | geringe Signalempfindlichkeit, eingeschränkter Empfangsfrequenzbereich; maximale Dämpfung von Spektren aus mindestens einem Frequenzunterband, daher beste Störfestigkeit gegen zusätzliche Funkdienstarten |

Aus den dargelegten Wirkungen der Einstellstufen des TV-Empfangsteils wird klar, dass die Einstellstufe 1 der Funktion eines konventionellen TV-Empfangsteils entspricht, welches keinerlei Maßnahmen zum Unterdrücken von Sendespektren zusätzlicher Funkdienstarten im Frequenzunterband beinhaltet.

Die Einstellstufe 1 kann für einen terrestrischen Fernsehempfang wie DVB-T oder über Analogrundfunk als Voreinstellung des TV-Empfangsteils im Auslieferungszustand eingesetzt werden, da die Einstellzustände den vollen Empfangsfrequenzbereich, der auch das Frequenzunterband einschließt, mit einer hohen Signalempfindlichkeit realisieren. Dadurch sind auch im Frequenzunterband Sendespektren von schwachen TV-Sendern empfangbar, sofern keine Sendespektren zusätzlicher Funkdienstarten in den Eingangskreis I_{HF} gelangen.

Da Kabelfernsehanlagen in der Regel TV-Spektren mit weitestgehend ähnlich hohen Pegelwerten verteilen, wird selten zum Empfangen von TV-Diensten die verfügbare hohe Signalempfindlichkeit benötigt. Damit kann der Vorverstärker G zum Verbessern der Großsignalfestigkeit und einer höheren Signalrobustheit gegen zusätzliche Funkdienstarten, die über Abschirmfehler in den in den Eingangskreis I_{HF} gelangen, als Voreinstellung für den Kabelfernsehempfang in den Bypass-Modus gesetzt werden.

Sobald die Demodulator-Einheit DEM anhand von benötigten Modulationsparametern entdeckt, dass der Eingangsanschluss TVI mit einer Kabelfernsehanlage verbunden ist, schaltet die Steuereinrichtung CTRL nach einer vorteilhaften Ausführung der Erfindung das TV-Empfangsteil präventiv in Einstellstufe 3. Damit ergeben die Einstellzustände des Vorverstärkers G und des Eingangsfilters FI eine bessere Großsignalfestigkeit bei einem uneingeschränkten Empfangsfrequenzbereich.

Zum Bestimmen weiterer Einstellstufen des TV-Empfangsteils anhand der aktuellen Empfangssituation in der Empfangsregion nutzt die Steuereinrichtung CTRL verschiedene Analyseroutinen.

In einer beispielhaften Ausführung der oben dargestellten Bandanalyse benutzt die Steuereinrichtung CTRL zur Dienstarterkennung die Demodulator-Einheit DEM und zum Selektieren der Dienste die HF-Abstimmeinheit TUN. Die Steuereinrichtung CTRL stellt während der Bandanalyse die HF-Abstimmeinheit sequentiell auf die TV-Kanäle in einem Frequenzunterband ein und fragt die Statussignalisierung am Statusausgang S_{STAT}, beispielsweise bezüglich der Empfangsqualität, ab. Die Dienstarterkennung nutzt den Umstand, dass ein im entsprechenden Frequenzunterband empfangbarer kanalkodierter Transportstrom zu einem DVB-Dienst gehört, sofern die Demodulator-Einheit DEM im Transportstrom Übertragungsfehler erkennen und korrigieren kann. Für diesen Zustand wird eine hohe Empfangsqualität signalisiert.

Zum Bestimmen der Empfangsqualität eines TV-Dienstes sind bereits verschiedene Messmethoden bekannt. So kann beispielsweise neben dem Erreichen von Mindestwerten für die HF-Trägerpegel in den empfangenen Sendespektren und/oder dem Signal-Rausch-Verhältnis die Steuereinrichtung CTRL verschiedene Fehlerraten, wie die Bitfehlerrate (BER), die Blockfehlerrate (BLER), die Modulationsfehlerrate (MER) oder die Paketfehlerrate (PER), einzeln oder in Kombination zum Definieren der Empfangsqualität oder zum Vergleichen der Ergebnisse von Einstellzuständen heranziehen.

Während des Sendersuchlaufs der Bandanalyse im Rasterabstand der TV-Kanäle leitet die Bypass-Verbindung BP alle empfangbaren Sendespektren unabhängig vom benutzten Übertragungsstandard und der Dienstart in den Eingangskreis I_{HF} und der Statusausgang S_{STAT} signalisiert der Steuereinrichtung CTRL, wenn ein umgesetztes HF-Quellensignal ein Sendespektrum enthält, dessen Transportmultiplex mit einem der intern installierten DVB-Demodulatoren demodulierbar ist.

Als Ergebnis der Bandanalyse trifft die Steuereinrichtung CTRL eine erste fundierte Entscheidung zum Einstellen des Eingangsfilters für den Wiedergabebetrieb. Wenn die Bandanalyse im entsprechenden Frequenzunterband keinen modulierten DVB-Transportstrom erkannte, wird davon ausgegangen, dass in der Empfangsregion ein terrestrischer TV-Dienst im Frequenzunterband aktuell arbeitet. Unabhängig davon, ob bereits andere Funkdienste im Frequenzunterband arbeiten, kann die Steuereinrichtung CTRL ohne Nachteil für den Empfängernutzer das Eingangsfilter FI im Wiedergabebetrieb von DVB-T-Betrieb zukünftig permanent in die Schaltposition II setzen, welche einen terrestrischen Empfang von TV-Diensten nur im eingeschränkten Empfangsfrequenzbereich zulässt. Da bei dieser Empfangssituation der Sendespeicher des TV-Empfangsteils keinen TV-Dienst in einem Frequenzunterband enthalten kann, wird zumindest im DVB-T-Wiedergabemodus die Abstimmeinheit TUN nicht mehr auf einen TV-Kanal im entsprechenden Frequenzunterband abgestimmt. Die permanent gesetzte Schaltposition II basiert also auf der Annahme, dass in der Empfangsregion das Frequenzunterband 1 für terrestrischen Fernsehrundfunk nicht mehr zur Verfügung steht.

Der Einstellzustand - Sperrzustand - für das Eingangsfilter FI hat den Vorteil, dass ein störender Zugang von Sendespektren aus dem Frequenzunterband zum Eingangskreis I_{HF} grundsätzlich gedämpft wird, ohne dass während der relativ kurzen Dauer der Bandanalyse ein Sendespektrum eines mobilen Funkdienstes gefunden wurde.

Die Steuereinrichtung CTRL bricht die Bandanalyseroutine ab, sobald die Bandanalyse das Sendespektrum eines TV-Dienstes im Frequenzunterband findet und lässt im Wiedergabebetrieb das Eingangsfilter FI in Schaltposition I - im Durchlasszustand. Die Entscheidung erfolgt auf der Basis, dass die aktuelle Empfangssituation in der Empfangsregion zur Zeit noch mindestens den uneingeschränkten Empfang eines terrestrischen TV-Dienstes im Frequenzunterband beinhaltet und andere Dienstarten nur so betrieben werden, dass ein ungestörter TV-Empfang möglich ist.

FIG. 2b zeigt eine alternative Ausführungsform gemäß der Erfindung mit einem Eingangsfilter FI, dass ein Anpassen eines TV-Empfangsteils an ein lokale Empfangssituation erlaubt, in der bereits verschiedene Frequenzunterbänder zur Nutzung durch Nicht-Rundfunkdienste frei gegeben worden sind. Wie bereits ausgeführt wurde, ist für die Erfindung die Struktur des Sperrfilters SF unwesentlich. Während in der Schaltposition II des HF-Umschalters S2 das Sperrfilter SF nur Frequenzunterband 1 unterdrückt, steht in der Schaltposition III ein Sperrfilter SF zur Verfügung, welches die Frequenzunterbänder 1 und/oder 2 unterdrückt.

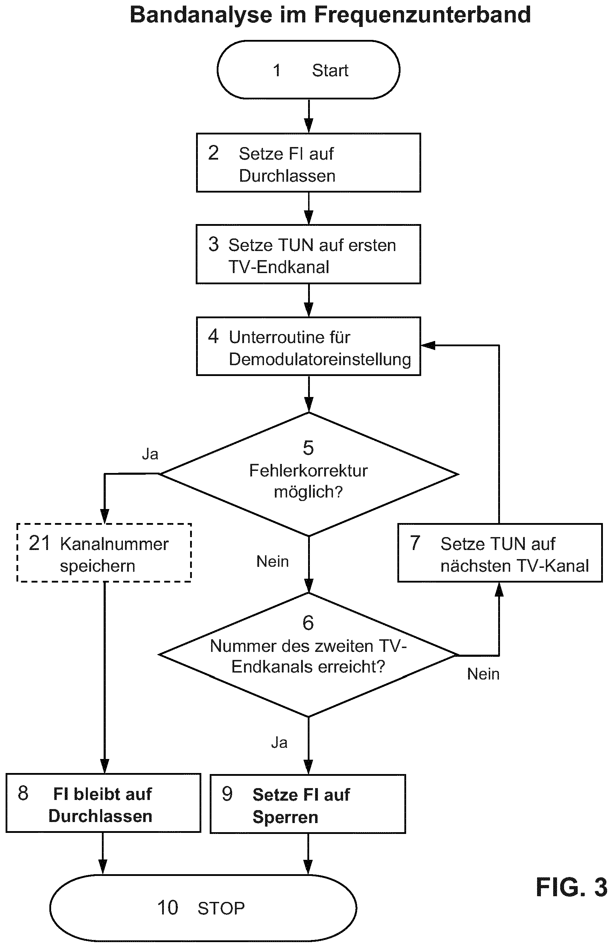

FIG. 3 zeigt ein Beispiel für den Ablauf der dargestellten Bandanalyseroutine zum Erkennen von aktiven TV-Diensten in Frequenzunterbändern. Vorteilhaft erfolgt die Bandanalyseroutine bei der Inbetriebnahme des TV-Empfangsteils am Empfangsort im Installationsmodus.

Nach dem Start der Bandanalyseroutine in Anweisung 1 stellt die Steuereinrichtung CTRL in Anweisung 2 das TV-Empfangsteil auf die Einstellstufe 1 gemäß der Tabelle 1, das heißt, den Vorverstärker G in den Verstärker-Modus und die HF-Umschalter S1, S2 jeweils in die Schaltposition I, um einen vollen Empfangsfrequenzbereich und eine hohe Signalempfindlichkeit für den Sendersuchlauf zu nutzen.

In einer Anweisung 3 stimmt die Steuereinrichtung CTRL die HF-Abstimmeinheit TUN auf einen ersten TV-Endkanal ab, der an einem Bandende eines Frequenzunterbandes liegt, beispielsweise dem TV-Kanal 60. Anschließend folgt eine Unterroutine 4 mit der Demodulator-Einheit DEM. Die Unterroutine 4 hat das Ziel, Einstellparameter zum benutzten DVB-Modulationsverfahren für das mit der HF-Abstimmeinheit TUN selektierte Sendespektrum S_{IF} zu finden.

Sofern die Unterroutine 4 einen passenden DVB-Demodulator und entsprechende Demodulator-Parameter für das umgesetzte Sendespektrum S_{IF} findet, ermöglicht die Fehlerkorrekturschaltung FEC in Abfrage 5 ein Inganghalten einer Fehlerkorrektur. Mit dem Ausführen der Fehlerkorrektur signalisiert der Statusausgang S_{STAT} der Steuereinrichtung CTRL, dass im entsprechenden Frequenzunterband noch ein TV-Dienst arbeitet und Anweisung 8 bewirkt, dass das TV-Empfangsteil in der Einstellstufe 1 bleibt. Dieses ermöglicht ein uneingeschränktes Empfangen von TV-Diensten auch im entsprechenden Frequenzunterband bei einer hohen Signalempfindlichkeit. Das Ausführen von Anweisung 8 hält die Bandanalyseroutine in Anweisung 10 an.

Sofern die Abfrage 5 jedoch signalisiert, dass die Unterroutine 4 zum umgesetzten Sendespektrum S_{IF} keinen DVB-Demodulator mit passenden Modulationsparametern gefunden hat, prüft die Steuereinrichtung CTRL in Abfrage 6, ob bereits der TV-Endkanal am anderen Bandende, im Beispiel der TV-Kanal 69, erreicht wurde.

Ein Erreichen des TV-Endkanals am anderen Bandende, ohne dass eine Fehlerkorrektur möglich war, hat zur Konsequenz, dass im Frequenzunterband kein aktiver TV-Dienst gefunden wurde. In diesem Fall signalisiert in Anweisung 9 der Statusausgang S_{STAT} der Steuereinrichtung CTRL, das Eingangsfilter FI in den Sperrzustand zu setzen. Das ist unabhängig vom Auffinden von Aktivitäten weiterer Funkdienstarten und ohne Empfangsnachteile möglich, weil gemäß der Bandanalyseroutine in keinem TV-Kanal des Frequenzunterbandes ein TV-Dienst arbeitet.

Solange das andere Bandende in Abfrage 6 noch nicht erreicht ist, dient Anweisung 7 in einem rückwärtigen Zweig zur Unterroutine 4 dazu, die HF-Abstimmeinheit TUN schrittweise auf den folgenden TV-Kanal des Frequenzunterbandes abzustimmen. Damit realisiert die Kanalanalyseroutine den Sendersuchlauf in TV-Kanalabständen zum Erkennen von TV-Diensten auf allen TV-Kanälen des Frequenzunterbandes.

In einer alternativen Ausführung der Erfindung kann die Steuereinrichtung CTRL beispielsweise bei jedem Start des TV-Empfangsteils einen Suchlauf im Frequenzunterband ausführen und den Einstellzustand des Eingangsfilters FI und/oder des Vorverstärkers G an eine sich geänderte Empfangssituation in der Empfangsregion selbsttätig anpassen.

Sobald die Steuereinrichtung CTRL mit der Abfrage 5 im Frequenzunterband einen TV-Dienst findet, trägt die Steuereinrichtung CTRL in einer optionalen Anweisung 21 die Kanalnummer für den im Frequenzunterband gefundenen TV-Dienst in die Permanentspeichermittel MEM der Datenbank ein und steuert das Eingangsfilter FI und/oder den Vorverstärker G nur beim Aufrufen des TV-Dienstes in die Einstellstufe 1.

Die Steuereinrichtung CTRL kann die Bandanalyse mit einen Suchlauf im Frequenzunterband mindestens bei jeder Inbetriebnahme am Empfangsort im Installationsmodus durchführen. Um das TV-Empfangsteil aber ständig an den aktuellen Stand der örtlichen Empfangssituation anzupassen, kann beispielsweise bei jedem Start des TV-Empfangsteils eine Bandanalyse ausgeführt und gegebenenfalls der Einstellzustand des Eingangsfilters FI und/oder des Vorverstärkers G korrigiert werden.

Sobald die Steuereinrichtung CTRL mit der Abfrage 5 im Frequenzunterband einen TV-Dienst findet, trägt die Steuereinrichtung CTRL in einer optionalen Anweisung 21 die Kanalnummer für den im Frequenzunterband gefundenen TV-Dienst in die Permanentspeichermittel MEM der Datenbank ein und steuert das Eingangsfilter FI und/oder den Vorverstärker G nur beim Aufrufen des TV-Dienstes in die Einstellstufe 1.

Die beschriebene Bandanalyseroutine zum Erkennen von aktiven TV-Diensten kann ab Anweisung 3 wiederholt werden. Dieses ermöglicht auch das weitere Frequenzunterband auf noch aktive TV-Dienste zu analysieren.

Somit kann automatisch der Status der nationalen Umsetzung von noch zu erwartenden Beschlüssen zur Bandbelegung der Rundfunkbänder mit Sendebetrieb von Nicht-Rundfunkdiensten in mindestens einem weiteren Frequenzunterband 2 berücksichtigt werden. Die Information zu einer möglichen Änderung der aktuellen Empfangssituation kann der Fernsehempfänger beispielsweise erst deutlich nach dem Fertigungsdatum über ein Software-Up-Date der Geräte-Software oder über Programmdaten für den elektronischen Programmführer erhalten.

Es ist jedoch nicht nötig, den Vorverstärker G und das Eingangsfilter FI beim Empfang von allen TV-Diensten in der Einstellstufe 1 zu halten. Sobald die Abstimmeinheit TUN auf einen TV-Dienst außerhalb eines Frequenzunterbandes eingestellt wird, kann die Steuereinrichtung CTRL selbsttätig zur Einstellstufe 2 wechseln.

In einer Erweiterung der Erfindung kann die Steuereinrichtung CTRL im Wiedergabebetrieb das Eingangsfilter FI grundsätzlich im Einstellzustand - Sperrzustand - lassen und nur dann in den uneingeschränkten Durchlasszustand umschalten, wenn der Gerätenutzer einen TV-Dienst im Frequenzunterband aufruft.

Die Bandanalyseroutine gemäß der Erfindung hat also prinzipiell die Aufgabe, die Empfangssituation am Empfangsort dahingehend zu analysieren, ob eine Notwendigkeit besteht, das Eingangsfilter FI für die Wiedergabe von TV-Diensten, die noch im Frequenzunterband arbeiten, in den Durchlasszustand zu setzen.

Um beim Empfangen von TV-Diensten außerhalb des Frequenzunterbandes präventiv dem Zugang potentieller Störspektren von zusätzlichen Funkdienstarten im Frequenzunterband zum Eingangskreis I_{HF} entgegenzuwirken, kann die Steuereinrichtung CTRL unabhängig vom Ergebnis der Bandanalyse die Einstellstufe 2 oder 4 ohne Nachteile einstellen.

Wie experimentelle Ergebnisse zeigten, ist eine grundsätzliche Zuordnung der Einstellzustände des Eingangsfilters zu TV-Spektren in Abhängigkeit von deren Trägerfrequenzlage in beziehungsweise außerhalb des Frequenzunterbands nicht möglich. Es hat sich beispielsweise gezeigt, dass ein in den Sperrzustand gesetztes Eingangsfilter FI auch den Empfang und die Wiedergabe von TV-Diensten unterhalb des Frequenzunterbands beeinflussen kann.

Um auszuschließen, dass TV-Dienste in TV-Kanälen unterhalb des Frequenzunterbands aufgrund fehlerhafter Einstellzustände für den Vorverstärker G und für das Eingangsfilter FI schlecht empfangbar sind, findet eine weitere Analyseroutine Anwendung. Sobald im Empfangsmodus des TV-Empfangsteils beim ausgewählten TV-Dienst die Empfangsqualität des TV-Dienstes einen Schwellwert unterschreitet, ermittelt eine sogenannte 'Kanalanalyseroutine' periodisch den Einstellzustand des Eingangsfilters FI und/oder des Vorverstärkers G, der eine beste Empfangsqualität liefert.

Im Gegensatz zur Bandanalyseroutine, welche vorteilhaft im Installationsmodus bei der Inbetriebnahme des TV-Empfangsteils am Empfangsort oder auch vorteilhaft beim Einschalten des TV-Empfangsteils ausgeführt wird, läuft die Kanalanalyseroutine im Empfangs- und Wiedergabemodus, beispielsweise auch während des TV-Empfangs zum Aufzeichnen von Sendungen.

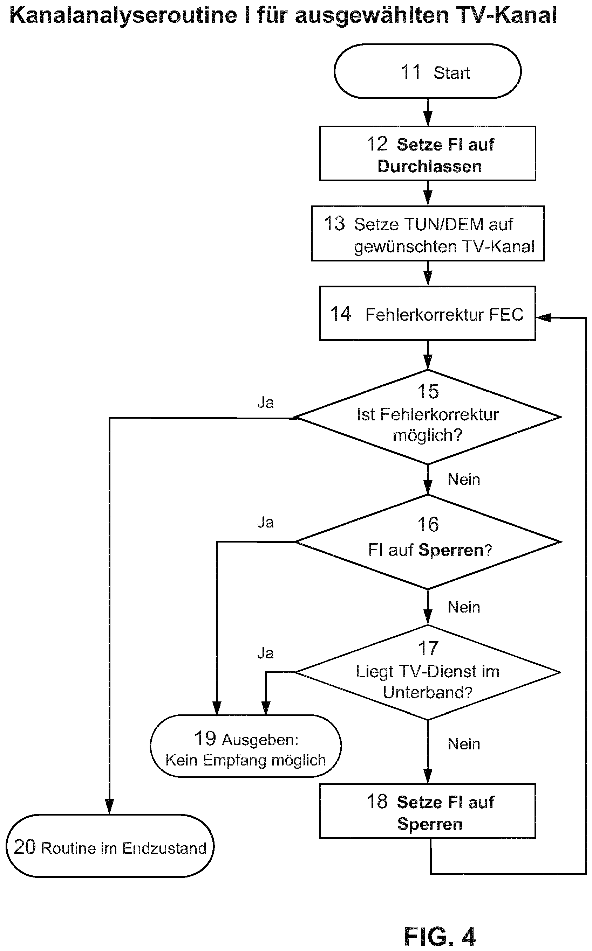

FIG. 4 zeigt eine Ausführungsform der Kanalanalyseroutine zum Bestimmen der Einstellstufen des TV-Empfangsteils im Empfangsmodus anhand der aktuellen Empfangssituation in der Empfangsregion. Die Kanalanalyseroutine soll im Empfangsmodus eines ausgewählten TV-Kanals zeitnah den Zugang aktueller Störspektren von zusätzlichen Funkdienstarten im Frequenzunterband zum Eingangskreis I_{HF} der Abstimmeinheit TUN eindämmen.

Vor jedem Programmwechsel im TV-Empfangsmodus durch den Nutzer ruft die Steuereinrichtung CTRL in Anweisung 11 die Kanalanalyseroutine auf und setzt in Anweisung 12 das Eingangsfilter FI auf den Durchlasszustand. Nachdem in Anweisung 13 die Abstimmeinheit TUN auf den TV-Kanal eines gewünschten TV-Dienstes eingestellt und für die Demodulator-Einheit DEM die entsprechenden Einstellparameter aus der Empfängerdatenbank erfragt wurden, beginnt in der Anweisung 14 im Empfangsmodus die Fehlerkorrekturschaltung FEC mit der Kanalanalyse für den aktuellen TV-Kanal.

In der Abfrage 15 wird die Fehlerkorrekturschaltung FEC der Demodulator-Einheit DEM abgefragt. Sobald eine Fehlerkorrektur über eine bestimmte Zeit beim eingestellten TV-Kanal möglich ist, endet mit Anweisung 20 bis zum nächsten Programmwechsel die Kanalanalyseroutine. Der Einstellzustand des Eingangsfilters FI bleibt im Endzustand unverändert.

Für den Fall, dass keine stabile Fehlerkorrektur möglich ist, prüft die Steuereinrichtung CTRL in Abfrage 16, ob das Eingangsfilter FI sich bereits im Sperrzustand befindet. Sofern dieses noch nicht in den Sperrzustand gesetzt wurde, prüft Abfrage 17, ob der TV-Kanal des aktuell gewünschten TV-Dienstes im Frequenzunterband liegt. Sollte der TV-Kanal außerhalb des Frequenzunterbandes liegen, so setzt Anweisung 18 das Eingangsfilter FI in den Sperrzustand.

Ein Rückführungszweig zur Anweisung 14, der Fehlerkorrekturschaltung FEC, führt dazu, dass die Steuereinrichtung CTRL prüft, ob mit dem Einstellzustand des Eingangsfilters FI tatsächlich eine Verbesserung der Empfangsqualität erreicht wurde.

Sofern die Abfrage 16 ergibt, dass sich das Eingangsfilter FI bereits im Sperrzustand befindet, erfolgt in Anweisung 19 eine Ausgabe in Form einer Anzeige und/oder akustischen Information an den Empfängernutzer, dass auf den eingestellten Kanal ein TV-Empfang möglich ist.

Vorteilhaft wird die Kanalanalyseroutine im Wiedergabemodus bei jedem Programmwechsel aufgerufen. Somit kann die Steuereinrichtung CTRL dynamisch auch nach der Installation am Empfangsort auf mögliche Störspektren reagieren.

Die in FIG. 4 dargestellte Kanalanalyseroutine I kann nur selbsttätig den besseren Einstellzustand des Eingangsfilters FI beim Empfang von ausgewählten TV-Diensten bestimmen. Damit lassen sich nur die in Tabelle 1 dargestellten Einstellzustände 1 und 2 realisieren. Diese Arbeitsweise entspricht der Darstellung des TV-Empfangsteils gemäß FIG. 1.

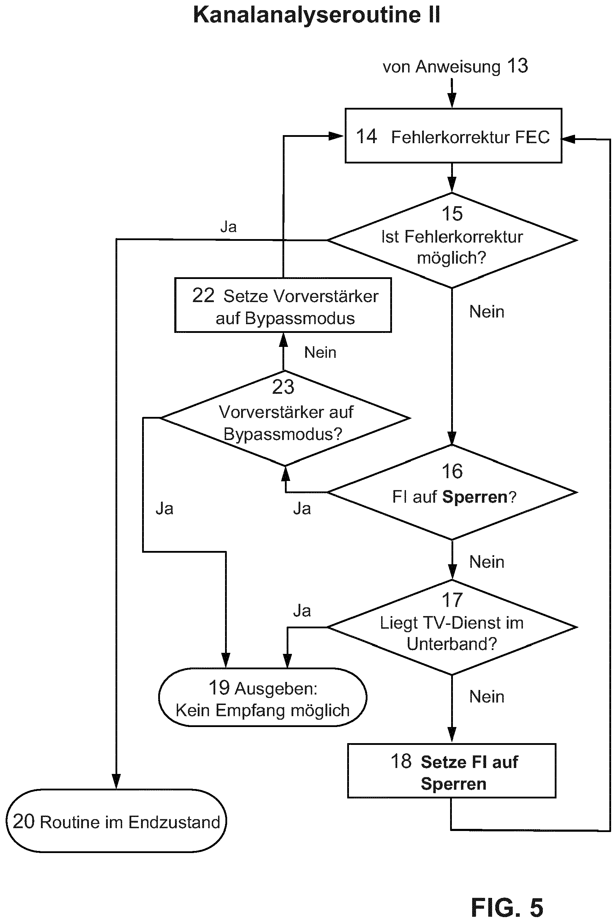

Im Gegensatz dazu zeigt FIG. 5 eine erweiterte Ausführung der Kanalanalyseroutine I nach FIG. 4 in einer verkürzten Darstellungsform, welche weitestgehend selbsttätig die Einstellzustände für den Vorverstärker G und das Eingangsfilter FI ermittelt.

Die Kanalanalyseroutine II nach FIG. 5 weist zusätzlich zur vorher dargestellten Kanalanalyseroutine I einen weiteren Rückführungszweig zur Anweisung 14 auf. Der Rückführungszweig enthält eine Anweisung 22, welche den Vorverstärker G zum Verbessern der Signalrobustheit in den Bypass-Modus setzt. Auf diese Weise realisiert die Steuereinrichtung CTRL die Einstellstufe 4, welche bei einem eingeschränkten Empfangsfrequenzbereich eine maximale Dämpfung von Spektren aus dem Frequenzunterband und damit eine beste Störfestigkeit gegen zusätzliche Funkdienstarten, beispielsweise durch Übersteuern von aktiven Bauelementen, realisiert. Die Einstellstufe 4 kann infolge der maximalen Signaldämpfung nur zum Fernsehempfang außerhalb des Frequenzunterbandes genutzt werden. Sobald mit der Abstimmeinheit TUN ein TV-Kanal ausgewählt wird, der im Frequenzunterband liegt, ist ein TV-Empfang auf dem ausgewählten TV-Kanal nicht möglich.

Eine Anfrage 23 überprüft, ob die Steuereinrichtung CTRL bereits sowohl das Eingangsfilter FI in den Sperrzustand als auch den Vorverstärker G in den Bypass-Modus gesetzt hat. Sind beide Bedingungen erfüllt und dennoch keine Fehlerkorrektur für das ausgewählte Sendespektrum möglich, wird die Steuereinrichtung CTRL in Anweisung 19 dem Empfängernutzer anzeigen, dass im ausgewählten TV-Kanal kein Fernsehempfang möglich ist.

Wie oben ausgeführt, erfordert die Kanalanalyseroutine einen kaum spürbaren Zeitaufwand und kann auch periodisch im Wiedergabemodus eines TV-Dienstes durchgeführt werden. Damit kann die Steuereinrichtung dynamisch auf sich ändernde Aktivitäten von störenden Funkdiensten im Frequenzunterband reagieren und effektiver auch auf temporär auftretende Störquellen, wie den sporadischen Sendebetrieb eines mobilen Endgerätes, kompensieren.

Die Steuereinrichtung CTRL setzt in beiden dargestellten Ausführungsformen die Kanalanalyseroutine in einen passiven Endzustand, sobald die Abfrage 15 signalisiert, dass die Fehlerkorrekturschaltung für das ausgewählte Sendespektrum problemlos eine Fehlerkorrektur ausführen kann. Es ist jedoch wünschenswert, dass das TV-Empfangsteil bei einem zufälligen Auftreten von Störspektren zusätzlicher Funkdienstarten im Frequenzunterband zeitnah den Zugang zum Eingangskreis I_{HF} unterdrücken soll, sobald diese den Empfang eines eingestellten TV-Dienstes durch ein Einbrechen der Empfangsqualität oder dem Verlust der Stabilität der Verbindung stören. In einer vorteilhaften Ausführung der Erfindung analysiert deshalb die Steuereinrichtung CTRL permanent oder periodisch, beispielsweise in Sekundenabständen, mithilfe der Demodulator-Einheit DEM die Empfangsqualitäten des mit der Abstimmeinheit eingestellten TV-Dienstes. Bei jedem Absinken der Empfangsqualität unter einem Mindestwert oder Verlust der Stabilität der Verbindung startet die Steuereinrichtung CTRL automatisch die Kanalanalyseroutine, um temporär auftretenden Sendespektren anderer Dienstarten durch Ändern der Einstellwerte entgegenzuwirken.

Ein Fachmann kann natürlich zur Umsetzung des mit den Patentansprüchen beanspruchten technischen Gegenstandes die beanspruchten Komponenten, wie Eingangsfilter FI und Vorverstärker G, variieren. Es können beispielsweise auch Eingangsfilter genutzt werden, welche vorrangig den Abwärtsbetrieb von Basisstationen oder den Aufwärtsbetrieb der mobilen Endgeräte sperren. Somit kann ausgeschlossen werden, dass TV-Kanäle aufgrund von Störungen aus dem Mobilfunknetz nicht empfangen werden können, beispielsweise durch Störungen des Aufwärtsbetriebs von mobilen Endgeräten auf der Spiegelfrequenz eines genutzten DVB-T-Kanals beziehungsweise infolge einer hohen Einfüge-Dämpfung des steuerbaren Sperrfiltermittels.

In einer vorteilhaften Weiterführung der Erfindung kann der Vorverstärker G nicht nur zwischen Bypass-Modus und Verstärkermodus geschalten werden, sondern auch zwischen unterschiedlichen Verstärkungen, beispielsweise zwischen Verstärkungen von 5dB bis 15dB.

Darüber hinaus kann vorteilhaft zum Verbessern der Signalrobustheit die Reihenfolge des Eingangsfilters FI und des Vorverstärker G im Eingangskreis I_{HF} getauscht werden.

In einer anderen vorteilhaften Ausführung der Erfindung weist der TV-Empfänger zum Bedienen und Konfigurieren durch den Benutzer eine Benutzeroberfläche auf. Die Benutzeroberfläche umfasst ein Einstellmenü, welches eine generelle Zu- oder Abschaltung des Eingangsfilters oder Vorverstärkers über einen Menüpunkt innerhalb der Software des Empfangsgerätes ermöglicht.

Darüber hinaus können nationale Statusdaten zum Nutzungsort des Fernsehempfängers aus der Datenbank der Benutzeroberfläche herangezogen werden, um das Eingangsfilter FI permanent in den Sperrzustand zu setzen, wenn der Nutzungsort in einem Land liegt, welches die Beschlüsse zu einer digitalen Dividende derart umgesetzt hat, dass im entsprechenden Frequenzunterband keine terrestrischen TV-Sender mehr arbeiten. Eine Aktualisierung der nationalen Statusdaten kann als Bestandteil von Up-Dates für die Geräte-Software oder den Programmdaten des elektronischen Programmführers übermittelt werden.

Auf diese Weise können dauerhaft alle Sendespektren aus dem Unterband unterdrückt werden, wenn dieses intensiv für Mobilfunk genutzt wird und keine Beeinflussung der Wiedergabe von TV-Diensten erfolgt.

Ein Fernsehempfänger, der gegenwärtig noch zum Empfang von TV-Diensten auf einen Kanal in einem der genannten Frequenzunterbänder abstimmbar sein muss, sollte ab einem unbestimmten Zeitpunkt durch eine Neukonfiguration Schutzmittel gegen Störungen von Nicht-Rundfunkdiensten aus diesen Frequenzunterbändern aufweisen. Der Vorteil der Erfindung besteht darin, dass der Fernsehempfänger mit einem geringen technischen Mehraufwand für die erfindungsgemäßen Mittel in Form eines geringen Anteils an zusätzlicher Hardware und einem zusätzlichen Softwaremodul die erforderliche Neukonfiguration automatisch vornimmt. Gemäß eines wesentlichen Vorteils der Erfindung können Nutzer eines TV-Empfängers an Empfangsorten, in denen terrestrische TV-Dienste auf TV-Kanälen im Frequenzunterband also beispielsweise den TV-Kanälen 61 bis 69 senden, diese wie gewohnt empfangen, obwohl an Empfangsorten, an denen im Frequenzunterband keine TV-Sender ausgestrahlt werden, das Frequenzunterband gefiltert wird, um Empfangsstörungen von TV-Diensten durch Sendespektren potentiell vorhandener beziehungsweise zukünftig in Betrieb genommener zusätzlicher Funkdienstarten zu dämpfen.

## Patentansprüche

1. TV-Empfangsteil für terrestrisch und/oder über Kabel verteilte TV-Dienste, welches eine Steuereinrichtung (CTRL) mit Permanentspeichermitteln (MEM) und zum frequenzselektiven Unterdrücken von Sendeleistung aus Sendespektren in wenigstens einem Frequenzunterband Eingangsfiltermittel (FI) aufweist, die den Zugang der Sendeleistung zu einem Eingangskreis (I_{HF}) einer Abstimmeinheit (TUN) des TV-Empfangsteils dämpfen,
wobei wenigstens ein innerhalb einer Empfangsregion durch verschiedene Funkdienstarten nutzbares Frequenzunterband in einem Rundfunkband eingeschlossen ist,
das TV-Empfangsteil ferner Erkennungsmittel aufweist und die Steuereinrichtung (CTRL) eingerichtet ist, mittels Analyseroutinen zu bewirken, dass:
• die Steuereinrichtung (CTRL) im Zusammenwirken mit der Abstimmeinheit (TUN) Sendersuchläufe zum Auffinden von Sendespektren ausführt,
• die Erkennungsmittel für eine Dienstarterkennung eine aktuelle Empfangssituation in der Empfangsregion anhand eines für selektierte Sendespektren benutzten Übertragungsstandards bestimmen und
• die Steuereinrichtung (CTRL) abhängig von der aktuellen Empfangssituation steuerbare Eingangsfiltermittel (FI) mit Einstellzuständen steuert, die einen uneingeschränkten Durchlasszustand und einen frequenzselektiven Sperrzustand umfassen, bei dem mindestens für einen Teilbereich eines Frequenzunterbandes eine Sperrdämpfung vorhanden ist,
• eine Bandanalyseroutine innerhalb eines Sendersuchlaufs mit im Durchlasszustand befindlichen steuerbaren Eingangsfiltermitteln (FI) im Frequenzunterband nach Sendespektren sucht,
• die Steuereinrichtung (CTRL) die steuerbaren Eingangsfiltermittel (FI) in den frequenzselektiven Sperrzustand setzt, sofern die Erkennungsmittel im abgesuchten Frequenzunterband keine Sendespektren entdecken, die den Übertragungsstandard eines TV-Dienstes nutzen, und
• die Steuereinrichtung (CTRL) die steuerbaren Eingangsfiltermittel (FI) in den Durchlasszustand schaltet, sofern die Erkennungsmittel im abgesuchten Frequenzunterband auf einem TV-Kanal mindestens ein Sendespektrum erkennen, das einem aktiven TV-Dienst zuzuordnen ist.

2. TV-Empfangsteil nach Anspruch 1, mit Anpassmitteln (G) im Eingangskreis (IHF) der Abstimmeinheit, die verschiedene Einstellzustände aufweisen, welche die Steuereinrichtung (CTRL) zum Anpassen der Eingangsempfindlichkeit und/oder Signalrobustheit an die aktuelle Empfangssituation in der Empfangsregion nutzt.

3. TV-Empfangsteil nach Anspruch 2, bei dem die Anpassmittel (G) im Eingangskreis (IHF) ein Vorverstärker ist, dessen Einstellzustände mindestens zwischen einem Verstärkermodus und einem Bypass-Modus umschaltbar ist.

4. TV-Empfangsteil nach Anspruch 1, bei dem die Steuereinrichtung (CTRL) von den Erkennungsmitteln entdeckte TV-Dienste in wenigstens einem Frequenzunterband identifiziert, markiert, in den Permanentspeichermitteln (MEM) einträgt und die steuerbaren Eingangsfiltermittel (FI) in den Durchlasszustand setzt, sofern die Abstimmeinheit (TUN) auf einen dieser entsprechend markierten TV-Dienste abgestimmt wird.

5. TV-Empfangsteil nach Anspruch 4, bei dem die Steuereinrichtung (CTRL) beim Abstimmen der Abstimmeinheit (TUN) auf nach Anspruch 4 markierte TV-Dienste die Dämpfung der steuerbaren Eingangsfiltermittel (FI) in wenigstens einem Bereich des Frequenzunterbandes reduziert.

6. TV-Empfangsteil nach Anspruch 1, bei dem im Sendersuchlauf eine Demodulator-Einheit (DEM) der Steuereinrichtung (CTRL) signalisiert, dass ein Sendespektrum gefunden wurde, das den Übertragungsstandard eines TV-Dienstes nutzt.

7. TV-Empfangsteil nach Anspruch 2, bei dem eine Kanalanalyseroutine mit der Steuereinrichtung (CTRL) und den Erkennungsmitteln alternative Einstellzustände für die steuerbaren Eingangsfiltermittel (FI) und/oder Anpassmittel (G) auswertet, während die Abstimmeinheit (TUN) auf einen TV-Kanal abgestimmt ist, um für TV-Dienste jeweils einen kanalbezogenen Einstellzustand für die steuerbaren Eingangsfiltermittel (FI) und Anpassmittel (G) zu bestimmen und bei einer Wiedergabe des TV-Dienstes kanalbezogen einzusetzen.

8. TV-Empfangsteil nach Anspruch 7, bei dem die Kanalanalyseroutine zum Analysieren eines empfangenen TV-Dienstes und zum Definieren der individuellen Einstellzustände:
• mit der Steuereinrichtung (CTRL) die Eingangsfiltermittel (FI) und/oder die Anpassmittel (G) nacheinander auf verschiedene alternative Einstellzustände setzt,
• jeweils den kanalbezogenen individuellen Einstellzustand der Eingangsfiltermittel (FI) und/oder Anpassmittel (G) mit Fehlererkennungsmitteln durch einen Vergleich von einstellzustands-abhängiger Empfangsqualität definiert und
• das Ergebnis des Vergleichs in den Permanentspeichermitteln (MEM) speichert, um bei jedem Aufruf zum Empfangen eines solchen TV-Dienstes die Eingangsfiltermittel (FI) und/oder die Anpassmittel (G) in den entsprechend definierten Einstellzustand zu setzen.

9. TV-Empfangsteil nach Anspruch 7, bei dem die Steuereinrichtung (CTRL) im Sendersuchlauf die Einstellzustände für die steuerbaren Eingangsfiltermittel (FI) und/oder Anpassmittel (G) für eine maximale Empfangsqualität anhand einer ausführbaren Korrekturfunktion von Fehlererkennungsmitteln (FEC) bestimmt.

10. Verfahren zum Steuern frequenzselektiver Eingangsfiltermittel (FI) und Anpassmittel (G) eines TV-Empfangsteils für terrestrisch und/oder über Kabel verteilte TV-Dienste, um einen Zugang von Sendeleistung aus Sendespektren in wenigstens einem Frequenzunterband zu einem Eingangskreis (IHF) einer Abstimmeinheit (TUN) des TV-Empfangsteils abhängig von einer aktuellen Empfangssituation in einer Empfangsregion zu verändern, wobei eine Steuereinrichtung (CTRL) das Verfahren an einem Nutzungsort des TV-Empfangsteils in Form von Analyseroutinen zum Bestimmen der aktuellen Empfangssituation in der Empfangsregion ausführt und wobei die Analyseroutinen die folgenden Verfahrensschritte umfassen:
• eine Steuereinrichtung (CTRL) führt mit der Abstimmeinheit (TUN) Sendersuchläufe zum Auffinden von Sendespektren aus,
• im Ergebnis eines Sendersuchlaufes bestimmen Erkennungsmittel für Dienstarten die aktuelle Empfangssituation in der Empfangsregion durch Auswerten des Medieninhalts der Sendespektren und
• die Steuereinrichtung (CTRL) steuert abhängig von der aktuellen Empfangssituation in der Empfangsregion die Eingangsfiltermittel (FI) und die Anpassmittel (G) in Einstellzustände, die einen Durchlasszustand und einen frequenzselektiven Sperrzustand umfassen, in dem mindestens für einen Teilbereich des Frequenzunterbandes eine Dämpfung realisiert wird,
• eine Bandanalyseroutine sucht innerhalb eines Sendersuchlaufs mit im Durchlasszustand befindlichen steuerbaren Eingangsfiltermitteln (FI) im Frequenzunterband nach Sendespektren,
• die Steuereinrichtung (CTRL) setzt die steuerbaren Eingangsfiltermittel (FI) in den frequenzselektiven Sperrzustand, sofern die Erkennungsmittel im abgesuchten Frequenzunterband keine Sendespektren entdecken, die den Übertragungsstandard eines TV-Dienstes nutzen, und
• die Steuereinrichtung (CTRL) schaltet die steuerbaren Eingangsfiltermittel (FI) in den Durchlasszustand, sofern die Erkennungsmittel im abgesuchten Frequenzunterband auf einem TV-Kanal mindestens ein Sendespektrum erkennen, das einem aktiven TV-Dienst zuzuordnen ist.

11. Verfahren nach Anspruch 10, bei dem die Demodulatoreinheit (DEM) anhand von benötigten Modulationsparametern entdeckt, wenn der Eingangsanschluss (TVI) mit einer Kabelfernsehanlage verbunden ist, und die Steuereinrichtung (CTRL) als Voreinstellung vor einer Analyseroutine die Eingangsfiltermittel (FI) in den Bypass-Modus schaltet.

12. Verfahren nach Anspruch 10, bei dem für einen terrestrischen Fernsehempfang die Steuereinrichtung (CTRL) als Voreinstellung vor einer Analyseroutine die Eingangsfiltermittel (FI) in den Durchlasszustand und die Anpassmittel (G) in den Verstärkermodus setzt, um den vollen Empfangsfrequenzbereich, der auch das Frequenzunterband einschließt, mit einer hohen Signalempfindlichkeit zu realisieren.

13. Verfahren nach Anspruch 10, bei dem die Steuereinrichtung (CTRL) die Empfangsqualitäten des mit der Abstimmeinheit eingestellten TV-Dienstes analysiert und bei einem Absinken der Empfangsqualität unter einem Mindestwert automatisch eine Kanalanalyseroutine startet.

14. Verfahren nach Anspruch 10, bei dem die Steuereinrichtung (CTRL) nationale Statusdaten über den Nutzungsort des Fernsehempfängers aus einer Datenbank nutzt, um das Eingangsfilter (FI) permanent in den Sperrzustand zu setzen, wenn der Nutzungsort in einem Land liegt, in dem im entsprechenden Frequenzunterband keine terrestrischen TV-Sender mehr arbeiten, wobei eine Aktualisierung der nationalen Statusdaten mit Up-Dates für die Geräte-Software oder den Programmdaten des elektronischen Programmführers übermittelt werden.

## Claims

1. TV reception component for TV services distributed terrestrially and/or by cable, comprising a controller (CTRL) having non-volatile storing means (MEM) and input filter means (FI) for the frequency-selective suppression of transmission power from broadcast spectra in at least one frequency sub-band, which attenuate the input of the transmission power to an input circuit (I_{HF}) of a tuning unit (TUN) of the TV reception component,
wherein at least one frequency sub-band usable by various radio service types within a reception region is enclosed in a broadcasting band,
**characterized in that**
the TV reception component further comprises recognition means and
that the controller (CTRL) is configured to cause, by means of analysis routines,
• the controller (CTRL) to perform channel scans for locating broadcast spectra in cooperation with the tuning unit (TUN),
• the recognition means to determine a current receiving situation in the reception region by means of a transmission standard used for selected broadcast spectra for a service type recognition, and
• the controller (CTRL) to control input filter means (FI) controllable depending on the current receiving situation with adjustment conditions comprising an unrestricted on-state and a frequency-selective off-state in which a stop-band attenuation is provided at least for a portion of a frequency sub-band,
• a band analysis routine to search for broadcast spectra within a channel scan by controllable input filter means (FI) which are in the on-state,
• the controller (CTRL) to set the controllable input filter means (FI) to the frequency-selective off-state, provided that the recognition means do not detect any broadcast spectra in the searched frequency sub-band which use the transmission standard of a TV service, and
• the controller (CTRL) to switch the controllable input filter means (FI) to the on-state, provided that the recognition means recognize at least one broadcast spectrum in the searched frequency sub-band on a TV channel, which can be assigned to an active TV service.

2. TV reception component according to claim 1, having adjustment means (G) in the input circuit (IHF) of the tuning unit which comprise various adjustment conditions, which the controller (CTRL) uses for adapting the input sensitivity and/or signal robustness to the current receiving situation in the reception region.

3. TV reception component according to claim 2, wherein the adjustment means (G) in the input circuit (IHF) is a preamplifier, the adjustment conditions of which are switchable at least between an amplifier mode and a bypass mode.

4. TV reception component according to claim 1, wherein the controller (CTRL) identifies and marks TV services detected by the recognition means in at least one frequency sub-band, registers them in the non-volatile storing means (MEM) and sets the controllable input filter means (FI) to the on-state, provided that the tuning unit (TUN) is tuned to one of these TV services marked correspondingly.

5. TV reception component according to claim 1, wherein the controller (CTRL) reduces the attenuation of the controllable input filter means (FI) in at least one range of the frequency sub-band when the tuning unit (TUN) is tuned to TV services marked according to claim 4.

6. TV reception component according to claim 1, wherein a demodulator unit (DEM) signals to the controller (CTRL) during the channel scan that a broadcast spectrum using the transmission standard of a TV service has been found.

7. TV reception component according to claim 2, wherein a channel analysis routine evaluates alternative adjustment conditions for the controllable input filter means (FI) and/or adjustment means (G) using the controller (CTRL) and the recognition means, while the tuning unit (TUN) is tuned to a TV channel, in order to respectively determine for TV services a channel-related adjustment condition for the controllable input filter means (FI) and adjustment means (G) and to use the same in a channel-related manner when reproducing the TV service.

8. TV reception component according to claim 7, wherein the channel analysis routine, for analyzing a received TV service and for defining the individual adjustment conditions,
• successively sets the input filter means (FI) and/or the adjustment means (G) to various alternative adjustment conditions using the controller (CTRL),
• respectively defines the channel-related individual adjustment condition of the input filter means (FI) and/or adjustment means (G) using error detection means by a comparison of a reception quality depending on an adjustment condition, and
• stores the result of the comparison in the non-volatile storing means (MEM), in order to set the input filter means (FI) and/or the adjustment means (G) to the correspondingly defined adjustment condition upon each request for receiving such a TV service.

9. TV reception component according to claim 7, wherein the controller (CTRL) determines the adjustment conditions for the controllable input filter means (FI) and/or adjustment means (G) in the channel scan for a maximum reception quality by means of an executable correction function of error detection means (FEC).

10. Method for controlling frequency-selective input filter means (FI) and adjustment means (G) of a TV reception component for TV services distributed terrestrially and/or by cable, in order to change an input of transmission power from broadcast spectra in at least one frequency sub-band to an input circuit (IHF) of a tuning unit (TUN) of the TV reception component depending on a current receiving situation in a reception region, wherein a controller (CTRL) performs the method at a place of use of the TV reception component in the form of analysis routines for determining the current receiving situation in the reception region, and wherein the analysis routines comprise the following method steps:
• a controller (CTRL) performs channel scans with the tuning unit for locating broadcast spectra,
• as a result of a channel scan, recognition means determine the current receiving situation in the reception region for service types by evaluating the media content of the broadcast spectra, and
• depending on the current receiving situation in the reception region, the controller (CTRL) controls the input filter means (FI) and the adjustment means (G) to adjustment conditions which comprise an on-state and a frequency-selective off-state, in which an attenuation is realized at least for a portion of the frequency sub-band,
• a band analysis routine searches broadcast spectra in the frequency sub-band within a channel scan using controllable input filter means (FI) which are in the on-state,
• the controller (CTRL) sets the controllable input filter means (FI) to the frequency-selective off-state, provided that the recognition means do not detect any broadcast spectra in the searched frequency sub-band, using the transmission standard of a TV service, and
• the controller (CTRL) sets the controllable input filter means (FI) to the on-state, provided that the recognition means recognize at least one broadcast spectrum in the searched frequency sub-band on a TV channel, which can be assigned to an active TV service.

11. Method according to claim 10, wherein the demodulator unit (DEM) detects by means of required modulation parameters when the input port (TVI) is connected to a cable television system, and the controller (CTRL) switches the input filter means (FI) to the bypass mode as a presetting before an analysis routine.

12. Method according to claim 10, wherein, for a terrestrial TV reception, the controller (CTRL) sets the input filter means (FI) to the on-state and the adjustment means (G) to the amplifier mode as a presetting before an analysis routine, in order to realize the complete reception frequency range which also comprises the frequency sub-band with a high signal sensitivity.

13. Method according to claim 10, wherein the controller (CTRL) analyses the reception qualities of the TV service adjusted with the tuning unit, and automatically starts a channel analysis routine when the reception quality falls under a minimum value.

14. Method according to claim 10, wherein the controller (CTRL) uses national status data regarding the place of use of the TV receiver from a database, in order to set the input filter (FI) permanently to the off-state if the place of use is in a country in which terrestrial TV channels are no longer operated in the corresponding frequency sub-band, wherein an actualization of the national status data is transmitted with updates for the device software or the program data of the electronic program guide.

## Revendications

1. Composant de réception de télévision pour des services de télévision diffusés par voie terrestre et/ou par câble, comportant une unité de commande (CTRL) ayant des moyens de mémoire permanente (MEM) et des moyens de filtre d'entrée (FI) pour supprimer une puissance d'émission de spectres d'émission de manière sélective en fréquence dans au moins une sous-bande de fréquence, qui atténuent l'entrée de la puissance d'émission dans un circuit d'entrée (I_{HF}) d'une unité d'accord (TUN) du composant de réception de télévision,
dans lequel au moins une sous-bande de fréquence utilisable par différents types de services de radio à l'intérieur d'une zone de réception est comprise dans une bande de radiodiffusion,
**caractérisé en ce que**
le composant de réception de télévision comprend en outre des moyens d'identification et
que l'unité de commande (CTRL) est configurée pour faire, moyennant des routines d'analyse, en sorte que :
• l'unité de commande (CTRL) procède à des recherches de chaînes pour trouver des spectres d'émission en coopération avec l'unité d'accord (TUN),
• les moyens d'identification déterminent une situation de réception actuelle dans la zone de réception moyennant une norme de transmission utilisée pour des spectres d'émission sélectionnées pour une identification de type de service, et
• l'unité de commande (CTRL) commande des moyens de filtre d'entrée (FI) contrôlables en fonction de la situation de réception actuelle avec des conditions de réglage comprenant un état de conduction sans restriction et un état de blocage sélectif en fréquence, dans lequel un affaiblissement hors-bande est prévu pour au moins une section d'une sous-bande de fréquence,
• une routine d'analyse de bande cherche des spectres d'émission dans la sous-bande de fréquence au sein d'une recherche de chaînes moyennant des moyens de filtre d'entrée (FI) contrôlables qui sont en l'état de conduction,
• l'unité de commande (CTRL) passe les moyens de filtre d'entrée (FI) contrôlables dans l'état de blocage sélectif en fréquence, à moins que les moyens d'identification ne trouvent des spectres d'émission dans la sous-bande de fréquence balayée, qui utilisent la norme de transmission d'un service de télévision, et
• l'unité de commande (CTRL) passe les moyens de filtre d'entrée (FI) contrôlables en l'état de conduction, pourvu que les moyens d'identification identifient au moins un spectre d'émission dans la sous-bande de fréquence balayée sur une chaîne de télévision, qui peut être attribué à un service de télévision actif.

2. Composant de réception de télévision selon la revendication 1, ayant des moyens d'ajustement (G) dans le circuit d'entrée (IHF) de l'unité d'accord, comprenant différentes conditions de réglage que l'unité de commande (CTRL) utilise pour adapter la sensibilité d'entrée et/ou la robustesse de signal à la situation de réception actuelle dans la zone de réception.

3. Composant de réception de télévision selon la revendication 2, dans lequel le moyen d'ajustement (G) dans le circuit d'entrée est un préamplificateur, dont les conditions de réglage peuvent être commutées au moins entre un mode amplificateur et un mode de dérivation.

4. Composant de réception de télévision selon la revendication 1, dans lequel l'unité de commande (CTRL) identifie, marque, enregistre dans les moyens de mémoire permanente (MEM) des services de télévision identifiés par les moyens d'identification dans au moins une sous-bande de fréquence et passe les moyens de filtre d'entrée (FI) contrôlables en l'état de conduction, pourvu que l'unité d'accord (TUN) est accordée sur un de ces services de télévision marqués conformément.

5. Composant de réception de télévision selon la revendication 1, dans lequel l'unité de commande (CTRL) réduit l'atténuation des moyens de filtre d'entrée (FI) contrôlables dans au moins une plage de la sous-bande de fréquence lors de l'accord de l'unité d'accord (TUN) sur des services de télévision marqués selon la revendication 4.

6. Composant de réception de télévision selon la revendication 1, dans lequel une unité de démodulateur (DEM) signale à l'unité de commande (CTRL) pendant la recherche de chaînes qu'un spectre d'émission a été trouvé qui utilise la norme de transmission d'un service de télévision.

7. Composant de réception de télévision selon la revendication 2, dans lequel une routine d'analyse de canal évalue des conditions de réglage alternatives pour les moyens de filtre d'entrée (FI) contrôlables et/ou les moyens d'ajustement (G) moyennant l'unité de commande (CTRL) et les moyens d'identification, pendant que l'unité d'accord (TUN) est accordée sur un canal de télévision, afin de déterminer pour des services de télévision une condition de réglage relative à un canal respectivement pour les moyens de filtre d'entrée (FI) contrôlables et les moyens d'ajustement (G) et pour l'utiliser lors d'une reproduction du service de télévision relativement à un canal.

8. Composant de réception de télévision selon la revendication 7, dans lequel, pour analyser un service de télévision reçu et pour définir les conditions individuelles de réglage, la routine d'analyse de canal :
• passe les moyens de filtre d'entrée (FI) et/ou les moyens d'ajustement (G) successivement à différentes conditions alternatives de réglage,
• respectivement définit la condition individuelle de réglage relative à un canal pour les moyens de filtre d'entrée (FI) et/ou les moyens d'ajustement (G) moyennant des moyens de détection d'erreurs par une comparaison d'une qualité de réception en fonction d'une condition de réglage, et
• enregistre le résultat de la comparaison dans les moyens de mémoire permanente (MEM), afin de passer les moyens de filtre d'entrée (FI) et/ou les moyens d'ajustement (G) dans la condition de réglage définie de manière correspondante.

9. Composant de réception de télévision selon la revendication 7, dans lequel l'unité de commande (CTRL) détermine les conditions de réglage pour les moyens de filtre d'entrée (FI) contrôlables et/ou les moyens d'ajustement (G) lors de la recherche de chaînes pour une qualité de réception maximale moyennant une fonction de correction exécutable de moyens de détection d'erreurs (FEC).

10. Procédé pour commander des moyens de filtre d'entrée (FI) et des moyens d'ajustement (G) sélectifs en fréquence d'un composant de réception de télévision pour des services de télévision diffusés par voie terrestre et/ou par câble, pour changer une entrée de puissance d'émission de spectres d'émission dans au moins une sous-bande de fréquence dans un circuit d'entrée (IHF) d'une unité d'accord (TUN) du composant de réception de télévision en fonction d'une situation de réception actuelle dans une zone de réception, dans lequel une unité de commande (CTRL) réalise le procédé à un lieu d'utilisation du composant de réception de télévision sous forme de routines d'analyse pour déterminer la situation de réception actuelle dans la zone de réception, et dans lequel les routines d'analyse comportent les étapes de procédé suivantes :
• une unité de commande (CTRL) procède à des recherches de chaînes avec l'unité d'accord (TUN), afin de trouver des spectres d'émission,
• à l'issue d'une recherche de chaînes, des moyens d'identification déterminent la situation de réception actuelle dans la zone de réception pour des types de service en évaluant le contenu média des spectres d'émission, et
• l'unité de commande (CTRL) commande, en fonction de la situation de réception actuelle dans la zone de réception, les moyens de filtre d'entrée (FI) et les moyens d'ajustement (G) en des conditions de réglage qui comportent un état de conduction et un état de blocage sélectif en fréquence, dans lequel une atténuation est réalisée au moins pour une section de la sous-bande de fréquence,
• une routine d'analyse de bande cherche des spectres d'émission dans la sous-bande de fréquence au sein d'une recherche de chaînes moyennant des moyens de filtre d'entrée (FI) contrôlables qui sont en l'état de conduction,
• l'unité de commande (CTRL) passe les moyens de filtre d'entrée (FI) contrôlables en l'état de blocage sélectif en fréquence, à moins que les moyens d'identification n'identifient des spectres d'émission dans la sous-bande de fréquence balayée, qui utilisent la norme de transmission d'un service de télévision, et
• l'unité de commande (CTRL) commute les moyens de filtre d'entrée (FI) contrôlables en l'état de conduction, pourvu que les moyens d'identification identifient au moins un spectre d'émission dans la sous-bande de fréquence sur un canal de télévision, qui peut être attribué à un service de télévision actif.

11. Procédé selon la revendication 10, dans lequel l'unité de démodulateur (DEM) détecte moyennant des paramètres de modulation requis quand le raccord d'entrée (TVI) est relié à un système de télévision par câble, et l'unité de commande (CTRL) commute les moyens de filtre d'entrée (FI) au mode de dérivation comme préréglage avant une routine d'analyse.

12. Procédé selon la revendication 10, dans lequel, pour une réception de télévision par voie terrestre, l'unité de commande (CTRL) passe les moyens de filtre d'entrée (FI) à la condition de conduction et les moyens d'ajustement (G) au mode d'amplificateur comme préréglage avant une routine d'analyse, afin de réaliser la gamme de fréquence de réception entière qui également comprend la sous-bande de fréquence avec une sensibilité de signal élevée.

13. Procédé selon la revendication 10, dans lequel l'unité de commande (CTRL) analyse les qualités de réception du service de télévision accordé avec l'unité d'accord, et automatiquement lance une routine d'analyse de canal lorsque la qualité de réception tombe à une valeur inférieure à une valeur minimale.

14. Procédé selon la revendication 10, dans lequel l'unité de commande (CTRL) utilise des données d'état nationales par rapport au lieu d'utilisation du récepteur de télévision d'une banque de données, pour mettre le filtre d'entrée (FI) de manière permanente en l'état de blocage, si le lieu d'utilisation se trouve dans un pays où il n'y a plus de chaînes de télévision terrestres opérant dans la sous-bande de fréquence correspondante, une actualisation des données d'état nationales étant transmise avec des mises à jour pour le logiciel du dispositif ou étant transmise aux données de programme du guide des programmes électronique.
